# EUROPEAN PATENT APPLICATION

(11) **EP 4 607 951 A1**
(43) Date of publication of application: **27.08.2025**
(21) Application number: 23937161.0
(22) Date of filing: 08.08.2023
(51) Int. Cl.: H04R 1/10

(54) **WEARING COMPONENT AND EARPHONE**

(30) Priority: 12.05.2023 CN 202310541798
(60) Divisional application: 25178895.6
(71) Applicant: Shenzhen Shokz Co., Ltd., Shenzhen, Guangdong 518108 (CN)
(72) Inventor: XIE, Shuailin, Shenzhen, Guangdong 518108 (CN); GUO, Burui, Shenzhen, Guangdong 518108 (CN); LI, Chaowu, Shenzhen, Guangdong 518108 (CN)
(74) Representative: Wang, Bo
(86) International application number: PCT/CN2023/111837
(87) International publication number: WO 2024/234485

(57) **Abstract**

A wearing assembly and an earphone are provided. The wearing assembly (30) includes an elastic metal wire (31), a lead assembly (32), an insert member (33), and a wrapping assembly (34). The insert member (33) is fixed to an end of the elastic metal wire (31) and includes an insert body (331). The wrapping assembly (34) includes a body wrapping portion (341) wrapping a periphery of the elastic metal wire (31) and the lead assembly (32), the lead assembly (32) has an exposed portion (320) that is exposed from the body wrapping portion (341) and extends to the insert body (331); and at least one of the insert body (331) and the wrapping assembly (34) further wraps a periphery of the exposed portion (320). The above solution uses at least one of the insert body (331) or the wrapping assembly (34) to wrap the periphery of the exposed portion (320) to improve a mounting yield of the wearing assembly (30).

## Description

### CROSS-REFERENCE TO RELATED APPLICATION

This application claims priority of Chinese Patent Application No. 202310541798.X, filed on May 12, 2023, the contents of each of which is entirely incorporated herein by reference.

### TECHNICAL FIELD

The present disclosure relates to the technical field of electronic devices, and in particular to a wearing assembly and a headphone.

### BACKGROUND

With the continuous popularization of an electronic device, the electronic device is becoming an indispensable social and entertainment tool in people's daily life. The electronic device such as a headphone is widely used in people's daily life, which is used in conjunction with a cell phone, a computer, and other terminal devices to facilitate a provision of an auditory feast for a user.

Taking the headphone as an example, the headphone may be disposed with a wearing assembly for the user to wear, and the wearing assembly often needs to include a lead. When the wearing assembly is fixed with other portions, if an adhesion between the lead and an adhesive used is poor, a fixing effect may be poor too.

### SUMMARY

The present disclosure provides a wearing assembly and a headphone. The wearing assembly includes an elastic metal wire, a lead assembly, an insert member, and a wrapping assembly. The insert member is fixed to an end of the elastic metal wire and includes an insert body, the wrapping assembly includes a body wrapping portion wrapping a periphery of the elastic metal wire and the lead assembly, the lead assembly has an exposed portion that is exposed from the body wrapping portion and extends to the insert body; at least one of the insert body and the wrapping assembly further wraps a periphery of the exposed portion.

In some embodiments, the insert body is provided with a hole path, and the exposed portion penetrates the hole path.

In some embodiments, a hole wall of the hole path surrounds a periphery of the exposed portion along a circumferential direction of the exposed portion in a closed manner.

In some embodiments, the wearing assembly further includes an epitaxial wrapping portion integrally molded with the body wrapping portion, the epitaxial wrapping portion wraps on an end of the insert body facing the body wrapping portion along a circumferential direction of the insert body and the other end of the insert body away from the body wrapping portion is exposed.

In some embodiments, a wrapping length of the epitaxial wrapping portion over the insert body in an insertion direction relative to the insert body is in a range of 0.2 mm-2.0 mm.

In some embodiments, the insert member further includes an epitaxial positioning portion protruding from an end surface of the insert body towards the body wrapping portion, and the epitaxial positioning portion is embedded within the body wrapping portion.

In some embodiments, the elastic metal wire is threaded within the epitaxial positioning portion.

In some embodiments, in a cross section perpendicular to an insertion direction of the insert body relative to a first insert groove, the insert body has a lengthwise direction and a widthwise direction, and the exposed portion is spaced apart from the elastic metal wire along the lengthwise direction or the widthwise direction.

In some embodiments, the insert body is provided with two slots spaced apart along the lengthwise direction, and the exposed portion and the elastic metal wire are disposed between the two slots in the lengthwise direction.

In some embodiments, the wrapping assembly further includes an epitaxial wrapping portion wrapping the periphery of the exposed portion of the lead assembly and partially covering the insert body in a circumferential direction of the insert body.

In some embodiments, a thickness of the epitaxial wrapping portion is less than a thickness of the body wrapping portion, and the epitaxial wrapping portion is connected to the body wrapping portion to form a step structure.

In some embodiments, the epitaxial wrapping portion is integrally molded with the body wrapping portion.

In some embodiments, a receiving groove is disposed on a surface of the insert body, and in a cross section perpendicular to an insertion direction of the insert body relative to a first insert groove, the receiving groove has an opening, the exposed portion is disposed within the receiving groove, the epitaxial wrapping portion is integrally molded with the body wrapping portion, and at least a part of the exposed portion disposed within the receiving groove has an externally visible region when viewed from the opening of the receiving groove, and the externally visible region is wrapped by the epitaxial wrapping portion.

In some implementations, a lengthwise direction of the receiving groove is provided along the insertion direction.

In some embodiments, the epitaxial wrapping portion further fills in a gap between the exposed portion and a groove wall of the receiving groove.

In some implementations, the wrapping assembly further includes an epitaxial insert portion integrally molded with the body wrapping portion, and the epitaxial insert portion contacts an end surface of the insert body towards the body wrapping portion.

In some embodiments, the insert member further includes an epitaxial positioning portion protruding from the end surface of the insert body, and the epitaxial positioning portion is embedded within the epitaxial insert portion.

In some embodiments, the insert member further includes an epitaxial positioning portion protruding from an end surface of the insert body towards the body wrapping portion, and the epitaxial positioning portion is embedded within the body wrapping portion.

In some embodiments, the elastic metal wire is threaded within the epitaxial positioning portion.

In some embodiments, in a cross section perpendicular to an insertion direction of the insert body relative to a first insert groove, the insert body has a lengthwise direction and a widthwise direction, and the exposed portion is spaced apart from the elastic metal wire along the lengthwise direction or the widthwise direction.

In some embodiments, the insert body is disposed with two slots spaced apart in the lengthwise direction, and the exposed portion and the elastic metal wire are disposed between the two slots in the lengthwise direction.

In some embodiments, a covering width of the epitaxial wrapping portion over the insert body in the circumferential direction of the insert body is less than or equal to one-fourth of a maximum circumferential length of the insert body.

The present disclosure also provides a headphone including the wearing assembly as described above, and a housing assembly disposed with a first insert groove, and the insert body is inserted in the first insert groove.

In some embodiments, the headphone further includes a sealant configured to seal a gap between at least one of the insert body or the wrapping assembly which wraps the exposed portion and a groove wall of the first insert groove. Surface wettability of the sealant on a surface of the at least one of the insert body and the wrapping assembly which wraps the exposed portion is greater than surface wettability of the sealant on a surface of the lead assembly.

In some embodiments, a material of the insulating coating is polytetrafluoroethylene (PTFE), and a material of the insert body is metal.

Beneficial effects of the present disclosure is that: by increasing at least one of the wrapping assembly and the insert body to protect the exposed portion, the adhesive cannot directly contact the exposed portion of the lead assembly, and by directly bonding at least one of the wrapping assembly and the insert body to the adhesive, a bonding effect of adhesive can be enhanced, thereby improving a fixing effect and a sealing effect, and a mounting yield of the wearing assembly can be improved.

### BRIEF DESCRIPTION OF THE DRAWINGS

The more clearly illustrate the technical solutions in the embodiments of the present disclosure, the following will briefly introduce the accompanying drawings that need to be used in the description of the embodiments, and it is obvious that the accompanying drawings in the following description are only some of the embodiments of the present disclosure, and other drawings may also be obtained according to these drawings without creative labor for those skilled in the art.
FIG. 1 is a schematic diagram illustrating a general assembly three-dimensional structure of a headphone according to an embodiment of the present disclosure;
FIG. 2 is an exploded structural diagram illustrating a movement assembly shown in FIG. 1;
FIG. 3 is a schematic diagram illustrating a cross section of an earhook assembly shown in FIG. 1;
FIG. 4 is a schematic diagram illustrating a decomposition structure of the earhook assembly shown in FIG. 3;
FIG. 5 is a schematic diagram illustrating another cross section of the earhook assembly shown in FIG. 3;
FIG. 6 is a schematic diagram illustrating an enlarged structure of a J region of the earhook assembly shown in FIG. 5;
FIG. 7 is a schematic diagram illustrating a cross section of the earhook assembly shown in FIG. 3 with some parts hidden;
FIG. 8 is a schematic diagram illustrating an enlarged structure of a K region of the earhook assembly shown in FIG. 7;
FIG. 9 is a schematic diagram illustrating another decomposition structure of the earhook assembly shown in FIG. 1;
FIG. 10 is a schematic diagram illustrating a cross section of the earhook assembly shown in FIG. 9;
FIG. 11 is a schematic diagram illustrating an enlarged structure of an R region of the earhook assembly shown in FIG. 10;
FIG. 12 is a schematic diagram illustrating another cross section of the earhook assembly shown in FIG. 9 with some parts hidden;
FIG. 13 is a schematic diagram illustrating an enlarged structure of a T region of the earhook assembly shown in FIG. 12;
FIG. 14 is a schematic diagram illustrating a partial structure of the headphone shown in FIG. 1;
FIG. 15 is a schematic diagram illustrating a decomposition structure of the structure shown in FIG. 14;
FIG. 16 is a schematic diagram illustrating a cross section of the structure shown in FIG. 14 along a P-P section line;
FIG. 17 is a schematic diagram illustrating a cross section of the structure shown in FIG. 14 along an R-R section line;
FIG. 18 is a schematic diagram illustrating another cross section of the structure shown in FIG. 14 along a P-P section line;
FIG. 19 is a schematic diagram illustrating an enlarged structure of a Q region shown in FIG. 16;
FIG. 20 is a schematic diagram of a partial structure of a wearable component shown in FIG. 15;
FIG. 21 is a schematic diagram illustrating partial structures of a stopper and an insert body shown in FIG. 15;
FIG. 22 is a schematic diagram illustrating another partial structure of the headphone shown in FIG. 1;
FIG. 23 is a schematic diagram illustrating a decomposition structure shown in FIG. 22;
FIG. 24 is a schematic diagram illustrating a cross section of the structure shown in FIG. 22 along an E-E section line;
FIG. 25 is a schematic diagram illustrating an enlarged structure of a Q region shown in FIG. 24;
FIG. 26 is a schematic diagram illustrating a cross section of the structure shown in FIG. 22 along a G-G section line;
FIG. 27 is a schematic diagram illustrating an enlarged structure of an H region of the headphone shown in FIG. 26;
FIG. 28 is a schematic diagram illustrating a partial structure of the headphone shown in FIG. 1;
FIG. 29 is a schematic diagram illustrating a cross section of the structure shown in FIG. 28 along an M-M section line;
FIG. 30 is a schematic diagram illustrating a structure of a housing assembly shown in FIG. 29;
FIG. 31 is a schematic diagram illustrating an enlarged structure of an A1 region shown in FIG. 29;
FIG. 32 is a schematic diagram illustrating a structure of a wearable assembly according to an embodiment of the present disclosure;
FIG. 33 is a schematic diagram illustrating an enlarged structure of an A2 region in FIG. 29;
FIG. 34 is a schematic diagram illustrating an exemplary partial structure of a rear hanging assembly shown in FIG. 1;
FIG. 35 is a schematic diagram illustrating another view of a structure of the rear hanging assembly shown in FIG. 34;
FIG. 36 is a schematic diagram illustrating a cross section of the rear hanging assembly shown in FIG. 34 along an insertion direction;
FIG. 37 is a schematic diagram illustrating another exemplary partial structural of the rear hanging assembly shown in FIG. 1;
FIG. 38 is a schematic diagram illustrating a cross section of a lead assembly of the rear hanging assembly shown in FIG. 34;
FIG. 39 is a schematic diagram illustrating another exemplary partial structure of the rear hanging assembly shown in FIG. 1; and
FIG. 40 is a schematic diagram illustrating a structure of an insert member of the rear hanging assembly shown in FIG. 39.

### DETAILED DESCRIPTION

The present disclosure is described in further detail below in conjunction with the accompanying drawings and embodiments. In particular, it is noted that the following embodiments are only used to illustrate the present disclosure, but do not limit the scope of the present disclosure. Similarly, the following embodiments are only part of the embodiments of the present disclosure rather than all of the embodiments, and all other embodiments obtained by those skilled in the art without creative labor fall within the scope of protection of the present disclosure.

References to "embodiments" in the present disclosure mean that particular features, structures, or characteristics described in conjunction with the embodiments are included in at least one embodiment of the present disclosure. It is understood by those skilled in the art both explicitly and implicitly that the embodiments described in the present disclosure are combined with other embodiments.

The following embodiment of the present disclosure describes an exemplary structure of a headphone 100.

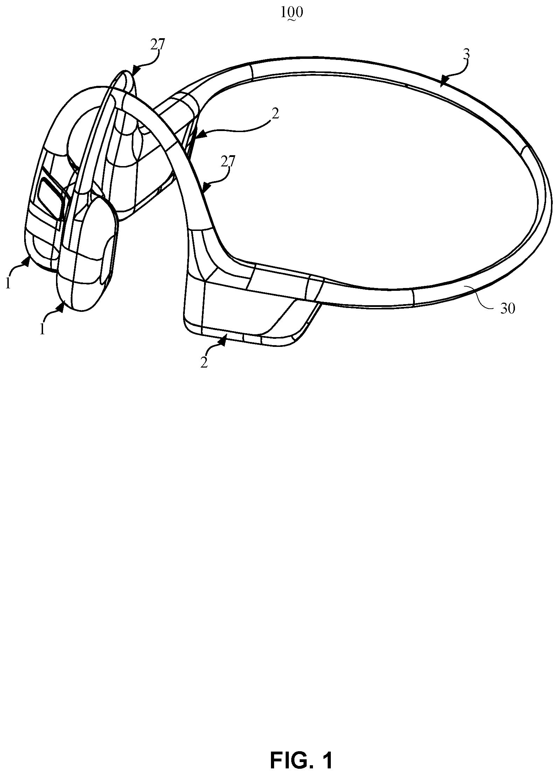

As shown in FIG. 1, the headphone 100 may include a movement assembly 1, an earhook assembly 2, and a rear hanging assembly 3. There are two movement assemblies 1. The two movement assemblies 1 are configured to transmit a vibration and/or a sound to left and right ears of a user, respectively. The two movement assemblies 1 may be the same or different. For example, one movement assembly 1 is disposed with a microphone, and the other movement assembly 1 is not disposed with the microphone. As another example, one movement assembly 1 is disposed with a key and a corresponding circuit board, and the other movement assembly 1 is not disposed with the key and the corresponding circuit board. The two movement assemblies 1 may be the same on a movement module (e.g. a speaker module). The movement assembly 1 described subsequently herein may be regarded as taking one of the two movement assemblies 1 as an example for a detailed illustration. There may be two earhook assemblies 2, and the two earhook assemblies 2 are located in the left and right ears of the user, respectively, so as to enable the movement assembly 1 to fit a face of the user. For example, one earhook assembly 2 is disposed with a battery, and the other earhook assembly 2 is disposed with a control circuit, etc. One end of the earhook assembly 2 is connected to the movement assembly 1, and the other end of the earhook assembly 2 is connected to the rear hanging assembly 3. The rear hanging assembly 3 connects the two ear hook assemblies 2, and the rear hanging assembly 3 is configured to wrap around a back of the neck or the head of the user and provides a clamping force so that the two movement assemblies 1 are clamped to both sides of a face of the user and the earhook assemblies 2 are more fixedly hang on the ears of the user. Of course, the headphone 100 may not include the rear hanging assembly 3, and the movement assemblies 1 are worn in the ears of the user via the earhook assemblies 2.

The following mainly describes an exemplary structure of the movement assembly 1 of the headphone 100, etc.

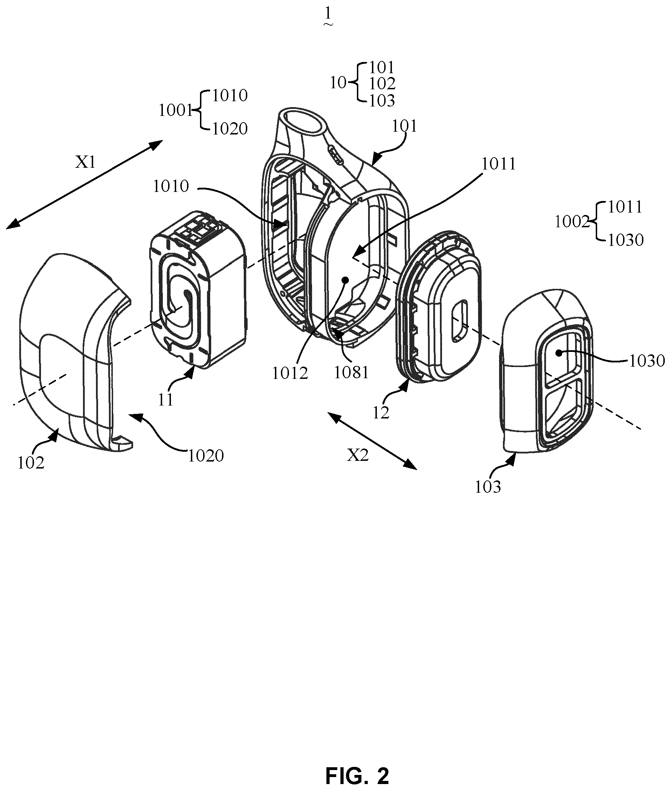

As shown in FIG. 2, the movement assembly 1 may include a housing assembly 10, a bone conduction speaker 11, and an air conduction speaker 12.

In some embodiments, the housing assembly 10 may be disposed with a receiving cavity 1001 and a receiving cavity 1002 that are isolated from each other. The housing assembly 10 may also be referred to as the movement housing assembly 10. The bone conduction speaker 11 is disposed within the receiving cavity 1001.

The air conduction speaker 12 conducts a sound into an ear canal of the user by means of air vibration, and the bone conduction speaker 11 conducts the sound to the user by means of bone conduction vibration. In some embodiments, a sealing of the receiving cavity 1001 is greater than a sealing of the receiving cavity 1002. The sealing may be regarded as an air tightness. As the receiving cavity 1002 in which the air conduction speaker 12 is placed needs to be connected to an outside world to facilitate a conduction of sound waves through air, the bone conduction speaker 11 and the air conduction speaker 12 are disposed independently from each other, and there is no need to dispose the bone conduction speaker 11 in the receiving cavity 1002. As the receiving cavity 1001 is set independently, the sealing of the accommodating cavities 1001 may be at a higher level, which effectively improves a sealing effect of the bone conduction speaker 11 and thereby preventing the bone conduction speaker 11 from being damaged by erosion of external environmental factors, and at the same time ensures a sound quality of the air conduction speaker 12. In addition, the headphone 100 may effectively reduce a mutual interference between the bone conduction speaker 11 and the air conduction speaker 12 when the bone conduction speaker 11 and the air conduction speaker 12 are working at the same time, thereby effectively improving the sound quality of the headphone 100.

In some embodiments, the housing assembly 10 includes a housing 101, a housing 102, and a housing 103, with the housing 101 and the housing 102 cooperating with each other to form the receiving cavity 1001. The housing 101 and/or the housing 102 further form a portion of the receiving cavity 1002, and the housing 103 may form another portion of the receiving cavity 1002, and further, the housing 103 and the housing 101 and/or the housing 102 cooperate with each other to form the receiving cavity 1002. In some embodiments, at least the housing 101 and the housing 102 cooperate together to form the receiving cavity 1001, and at least the housing 103 and the housing 101 cooperate together to form the receiving cavity 1002.

In some embodiments, a vibration direction of the bone conduction speaker 11 is disposed in a crosswise direction with a vibration direction of the air conduction speaker 12, and the housing 101 and the housing 102 cooperate with each other along the vibration direction of the bone conduction speaker 11. The housing 103 cooperates with the housing 101 and/or the housing 102 along the vibration direction of the air conduction speaker 12.

The vibration direction of the bone conduction speaker 11 may also be referred to herein as a bone conduction vibration direction X1, and the vibration direction of the air conduction speaker 12 may also be referred to herein as an air conduction vibration direction X2. The bone conduction vibration direction X1 and the air conduction vibration direction X2 are set at a cross instead of being parallel to each other. For example, the bone conduction vibration direction X1 and the air conduction vibration direction X2 are set perpendicularly or approximately perpendicular to each other (e.g., 90°±10°). When the bone conduction speaker 11 and the air conduction speaker 12 are working simultaneously, the bone conduction speaker 11 and the air conduction speaker 12 are vibrating along the bone conduction vibration direction X1 and the air conduction vibration direction X2, respectively. As the two vibration directions are set crosswise, an impact of the vibration of the bone conduction speaker 11 on the sound quality of the air conduction speaker 12 due to the vibrations of the bone conduction speaker 11 and the air conduction speaker 12 in the same direction may be effectively relieved.

Referring to FIG. 2, in some embodiments, the housing assembly 10 may also be disposed with a pressure relief hole 1081 for connecting the receiving cavity 1002 and the external environment. The pressure relief hole 1081 is disposed to extend toward a side where the receiving cavity 1001 is located. The housing assembly 10 is disposed with the pressure relief hole 1081 for relieving pressure for the air conduction speaker 12. The pressure relief hole 1081 connects the receiving cavity 1002 to the external environment, and the pressure relief hole 1081 extends from a connection with the receiving cavity 1002 toward a side where the receiving cavity 1001 is located.

The housing assembly 10 may include an interval wall 1012 for separating the receiving cavity 1001 from the receiving cavity 1002, with at least a portion of the interval wall 1012 extending toward the side where the receiving cavity 1001 is located and forming a portion of a hole wall of the pressure relief hole 108. The interval wall 1012 is disposed on the housing 101, and the housing 101 is disposed with a sub-receiving cavity 1010 and a sub-receiving cavity 1011 disposed on opposite sides of the interval wall 1012, and an opening direction of the sub-receiving cavity 1010 is along a wall surface of the interval wall 1012. Specifically, the opening direction of the sub-receiving cavity 1010 is parallel or substantially parallel to the wall surface of the interval wall 1012. The opening direction of the sub-receiving cavity 1011 is disposed crosswise with the wall surface of the interval wall 1012. The housing 102 is provided with a sub-receiving cavity 1020, the housing 102 caps an open end of the sub-receiving cavity 1010, and the sub-receiving cavity 1020 cooperates with the sub-receiving cavity 1010 to form the receiving cavity 1001. The housing 103 is provided with a sub-cavity 1030, the housing 103 caps an open end of the sub-cavity 1011, and the sub-cavity 1030 cooperates with the sub-cavity 1011 to form the receiving cavity 1002.

The following proceeds to describe primarily the structure of the earhook assembly 2, etc., of the headphone 100.

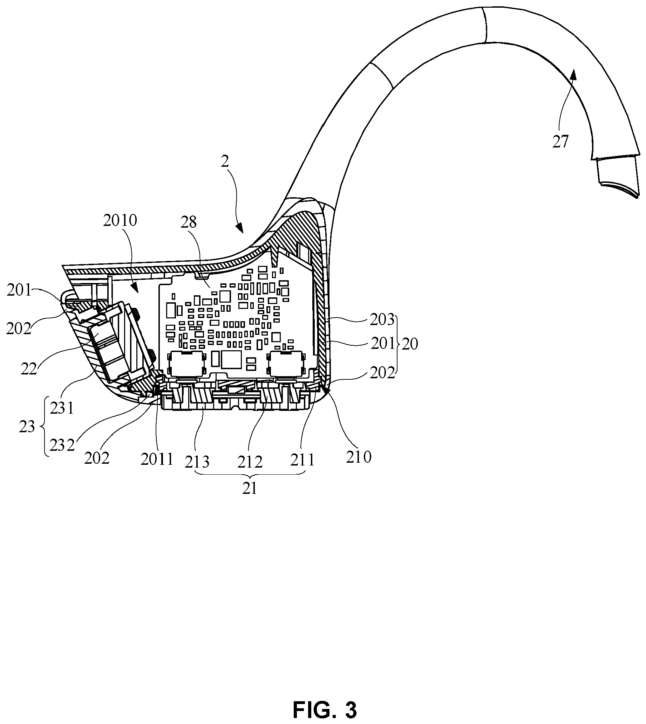

Combining FIGs. 3-5, the earhook assembly 2 may include a housing assembly 20 and a key assembly 21. The housing assembly 20 includes a housing 201 and a housing 202. The housing 201 is provided with a receiving cavity 2010 with at least an open end 2011. The key assembly 21 is at least partially inserted into the receiving cavity 2010 through the open end 2011, and the key assembly 21 cooperates with the housing 201 to form an adhesive receiving groove 210 that is visible externally from the housing 201 through the open end 2011. The housing 202 is disposed over the open end 2011 of the housing 201 and covers the adhesive receiving groove 210. The open end 2011 refers to an end of the housing 201 disposed with an opening.

In some embodiments, a circuit board 28 is disposed within the receiving cavity 2010. The circuit board 28 is configured to perform a conversion processing on an electrical signal to support the implementation of various functions of the headphone 100. The key assembly 21 is configured to accept a press of the user to be active relative to the circuit board 28, thereby triggering the circuit board 28 to operate. For example, the key assembly 21 triggers the circuit board 28 to realize the functions such as switching on/off, switching playback content, increasing/decreasing a sound volume, etc., of the headphone 100 when pressed by the user.

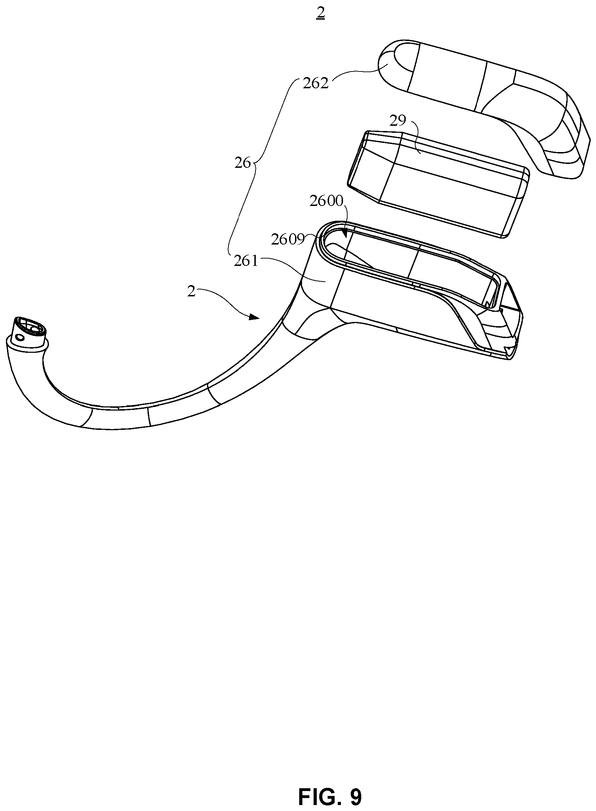

Combining FIG. 9, a battery 29 may also be disposed within the receiving cavity 2010. In some embodiments, the battery 29 is disposed in one of the two housing assemblies 20 of the earhook assembly 2, and the circuit board 28 is disposed in another one of the two housing assemblies 20. The two housing assemblies 20 may be the same or different.

In some embodiments, one side of the circuit board 28 may be connected to a lead within the receiving cavity 2010, and the other side of the circuit board 28 is near the open end 2011 and abuts against the key assembly 21. The circuit board 28 may be assembled into the receiving cavity 2010 through the open end 2011. The circuit board 28 may be limited within the receiving cavity 2010 by capping the housing 202 over the open end 2011 of the housing 201. By disposing the housing 202 to cover the adhesive receiving groove 210, the headphone 100 may be made more aesthetically pleasing. The housing 202 may also limit a portion of the key assembly 21 within the receiving cavity, thereby limiting the key assembly 21 from detaching from the housing 201. In some embodiments, the housing 202 partially or fully covers the adhesive receiving groove 210.

A adhesive may be disposed between the key assembly 21 and the housing 201. Here, the adhesive may be a generic term, and the adhesive may be of various forms, such as a solid adhesive, a liquid adhesive, a semi-solid adhesive, etc., which is configured to serve as a sealing or fixing function. The adhesive may form a sealing between the key assembly 21 and the housing 201 to improve a waterproof performance of the headphone 100. The adhesive may also act as an adhesive fixing. When dispensing the adhesive, the adhesive, for example, may be in the form of a fluid, and the adhesive may be cured after a period of time.

If the adhesive receiving groove 210 is not disposed, the adhesive needs to be pre-applied between the key assembly 21 and the housing 201 along the insertion direction before an insert mounting of the key assembly 21 is performed. When mounting the key assembly 21, the key assembly 21 is likely to squeeze the adhesive into the receiving cavity 2010, thereby affecting a normal operation of the headphone 100. The adhesive receiving groove 210 may be configured to hold the adhesive. By disposing the adhesive receiving groove 210, if the dispensing of adhesive is performed after the insertion and mounting of the key assembly 21, the adhesive is effectively prevented from being pressed into the receiving cavity 2010 by the key assembly 21. By disposing the adhesive receiving groove 210 to be visible from the outside of the housing 201 through the open end 2011, it is easy to perform the dispensing operation of the adhesive, and to control an amount of adhesive dispensed to reduce a risk of the headphone 100 being poorly sealed due to the amount of adhesive dispensed being too small, and to reduce a probability of the adhesive seeping out to an outer surface of the housing 201 or seeping into the receiving cavity 2010 due to too much adhesive being dispensed, so as to minimize an adverse effect on the appearance of the headphone 100 and an operation state of the headphone 100.

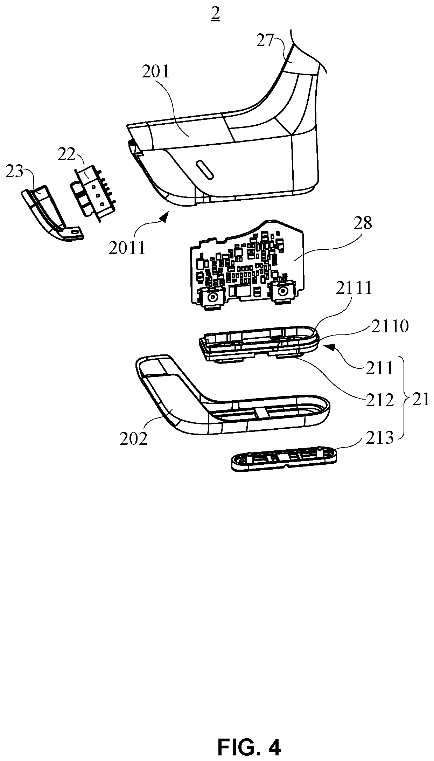

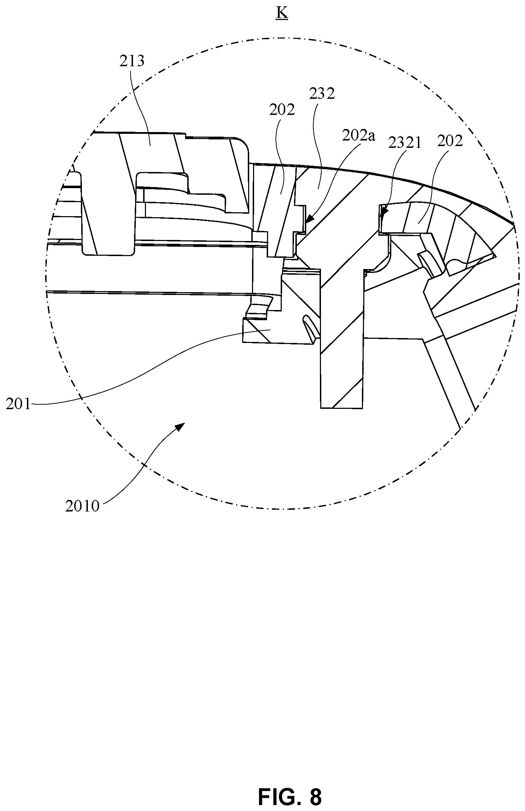

As shown in FIG. 4, FIG. 6, and FIG. 8, the key assembly 21 may include a key support 211, an annular protrusion 2110 is disposed on an outer wall surface of the key support 211, an annular support platform 2012 is disposed on an inner wall surface of the housing 201, the annular protrusion 2110 is supported on the annular support platform 2012, and the annular protrusion 2110 sinks for a certain distance relative to the open end 2011. On a side of the annular protrusion 2110 towards the open end 2011, the outer wall surface of the key support 211 and the inner wall surface of the housing 201 cooperate with each other to form the adhesive receiving groove 210.

By disposing the annular protrusion 2110 to be supported on the annular support platform 2012, the annular support platform 2012 limits a movement of the key support 211 toward the receiving cavity 2010, enabling the key support 211 to be stably supported on the housing 201. When assembling the key support 211, the annular support platform 2012 may play a role in positioning the key support 211, making it easy for the key support 211 to be mounted in place, thereby improving an assembly efficiency. Additionally, the annular protrusion 2110 is supported on the annular support platform 2012 to make a flow path for the adhesive flowing into the receiving cavity 2010 to be narrow and zigzagging, which reduces the flow of the adhesive from the adhesive receiving groove 210 to the receiving cavity 2010 when dispensing the adhesive.

By disposing the annular protrusion 2110 to sink for a certain distance relative to the open end 2011, the annular protrusion 2110 may form a bottom wall of the adhesive receiving groove 210. In contrast to forming the adhesive receiving groove 210 in an integrally molded manner, forming the adhesive receiving groove 210 in a split molding manner through the key support 211 and the housing 201 being abut against each other makes the assembly of the headphone 100 more flexible and thus easier to assemble.

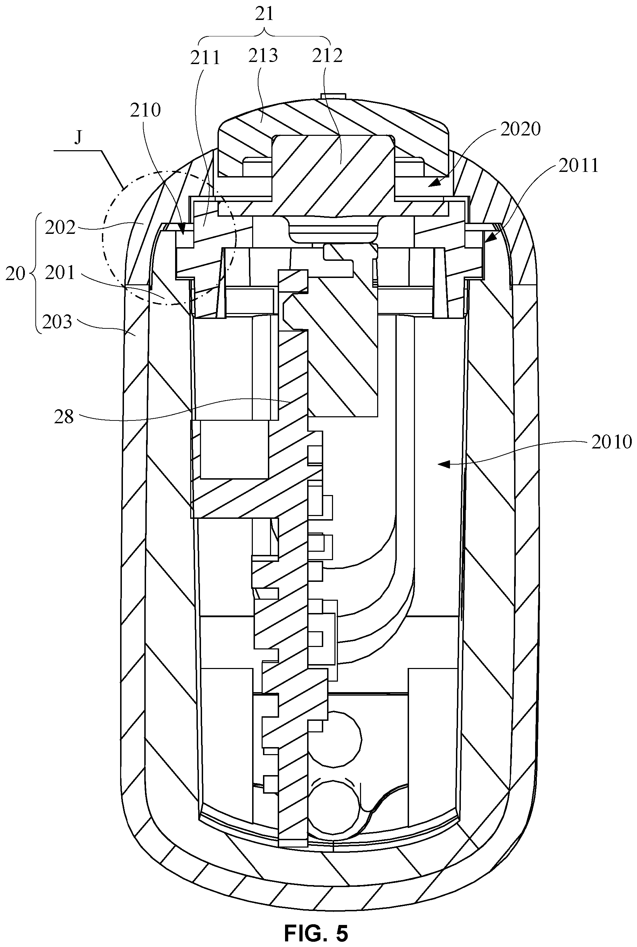

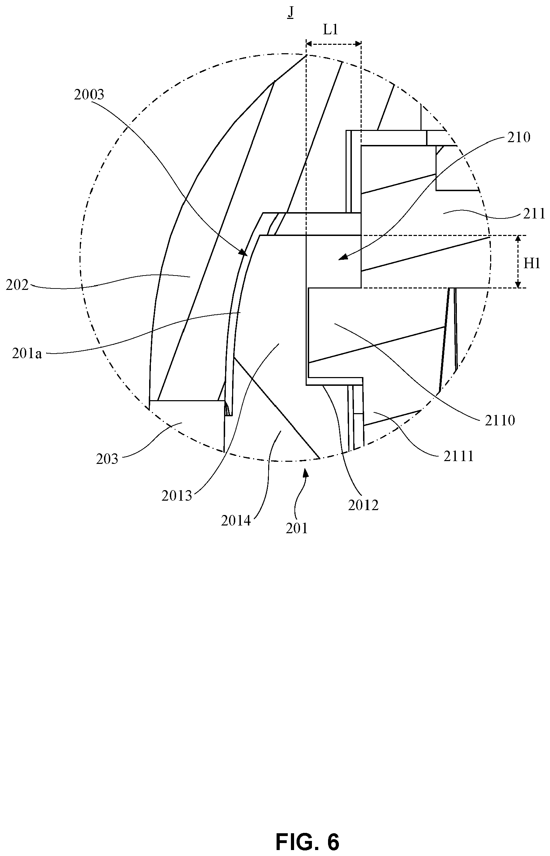

In some embodiments, as shown in FIG. 5 and FIG. 6, an outer end surface of the key support 211 on a side away from the receiving cavity 2010 protrudes from the open end 2011, and the key assembly 21 includes an elastic pressing member 212 disposed on the outer end surface, a housing 202 is disposed with a keyhole 2020, and the elastic pressing member 212 is exposed through the keyhole 2020. By disposing the outer end surface of the side of the key support 211 away from the receiving cavity 2010 protruding from the open end 2011, the flow of adhesive towards the key assembly 21 may be limited when the adhesive overflows from the adhesive receiving groove 210.

When the user presses the side of the key assembly 21 away from the receiving cavity 2010, the elastic pressing member 212 may elastically deform. The elastic pressing member 212 may be restored when the user releases the key assembly 21. The pressing action of the user may be transmitted to a switching circuitry on the circuit board 28 through the elastic deformation or deformation restoration of the elastic pressing member 212, thereby triggering the circuit board 28 to operate. The elastic deformation or deformation restoration of the elastic pressing member 212 may be allowed by disposing the keyhole 2020, which also allows the press action exerted by the user to be transmitted to the circuit board 28.

In some embodiments, as shown in FIG. 5, the key assembly 21 includes an outer pressing member 213. A portion of the outer pressing member 213 is inserted into the keyhole 2020, and another portion of the outer pressing member 213 protrudes from the outer surface of the housing 202 to be pressed by the user. The outer pressing member 213 abuts against the elastic pressing member 212, and the pressing action of the user may be transmitted to the elastic pressing member 212 through the outer pressing member 213.

As shown in FIG. 5 and FIG. 6, in the insertion direction of the key assembly 21 relative to the receiving cavity 2010, the housing 201 includes a first wall portion 2013 and a second wall portion 2014 connected to each other, with the second wall portion 2014 located on a side of the first wall portion 2013 away from the open end 2011, and the annular support platform 2012 is located at a connection between the first wall portion 2013 and the second wall portion 2014. Specifically, the inner wall surface of the first wall portion 2013 and the inner wall surface of the second wall portion 2014 are connected by the annular support platform 2012. The key support 211 includes an insert portion 2111 disposed on the side of the annular protrusion 2110 away from the open end 2011, and the insert portion 2111 is inserted into a space enclosed by the second wall portion 2014.

In some embodiments, an outer peripheral dimension of the insertion portion 2111 may match an inner peripheral dimension of the second wall portion 2014. The second wall portion 2014 may act to position the insert portion 2111, limit a relative movement between the key support 211 and the housing 201, so that the adhesive receiving groove 210 stably exists, which is conducive to dispensing the adhesive.

As shown in FIG. 5 and FIG. 6, the housing assembly 20 further includes an elastic wrapping layer 203 wrapped on the outer surface of the housing 201. On a side of the open end 2011, the housing 201 has an exposed portion 201a that is not wrapped by the elastic wrapping layer 203. The exposed portion 201a is inserted within the housing 202, and the housing 202 is abut against the elastic wrapping layer 203 in an insertion direction of the exposed portion 201a relative to the housing 202.

By disposing the elastic wrapping layer 203 on the outer surface of the housing 201, a comfort of the user when holding the headphone 100 is improved, and a friction is increased. By inserting the exposed portion 201a of the housing 201 into the housing 202, the housing 201 may act to position the housing 202, which limits the relative movement between the housing 201 and the housing 202 and improves a connection stability between the housing 201 and the housing 202.

By disposing the exposed portion 201a of the housing 201 as not being wrapped by the elastic wrapping layer 203, the elastic wrapping layer 203 may be avoided from interfering with the connection between the housing 201 and the housing 202. By disposing the housing 202 to abut against the elastic wrapping layer 203 in the insertion direction of the exposed portion 201a relative to the housing 202, the outer surface of the housing 202 and the outer surface of the elastic wrapping layer 203 are made to flush at the abutment portion, which on the one hand makes the housing 202 and the elastic wrapping layer 203 more tightly packed at the abutment portion, which plays a better sealing effect, thereby reducing an entry of debris and water vapor, and improves a service life of the elastic wrapping layer 203, and on the other hand the flushness at the abutment portion reduces a discomfort caused by the user when touched, which makes the headphone 100 more integrally stronger and more comfortable, and also makes the headphone 100 more aesthetically pleasing in appearance.

In some embodiments, the housing 202 is not wrapped by the elastic wrapping layer 203, so that the side of the key assembly 21 away from the receiving cavity 2010 is spaced apart from the elastic wrapping layer 203, thereby avoiding the elastic wrapping layer 203 from interfering with the pressing of the user on the key assembly 21 which affects a pressing feeling of the user.

As shown in FIG. 5 and FIG. 6, the exposed portion 201a cooperates with the housing 202 to form an adhesive receiving gap 2003 for connecting the adhesive receiving groove 210. The adhesive receiving gap 2003 may receive adhesive so that a seal is formed between the exposed portion 201a and the housing 202, and the exposed portion 201a is fixed to the housing 202.

In some embodiments, the outer end surface of the key support 211 on a side away from the receiving cavity 2010 is set to protrude from the open end 2011, allowing the adhesive to flow to the adhesive receiving gap 2003 as the adhesive overflows the adhesive receiving groove 210. In some embodiments, before assembling the housing 201 with the housing 202, the dispensing of adhesive may be performed on an outer side of the exposed portion 201a or on an inner side of the housing 202, such that the adhesive fills the adhesive receiving gap 2003 after the exposed portion 201a and the housing 202 cooperate to form the adhesive receiving gap 2003.

As shown in FIG. 5 and FIG. 6, a depth H1 of at least a portion of the adhesive receiving groove 210 is greater than or equal to 0.2 mm in the insertion direction of the key assembly 21 relative to the adhesive receiving cavity 2010. For example, the depth H1 is 0.25 mm, 0.3 mm, 0.35 mm, 0.4 mm, or 0.5 mm. In some embodiments, a width L1 of at least a portion of the adhesive receiving groove 210 is greater than or equal to 0.4 mm in a vertical direction of the insertion direction of the key assembly 21 relative to the receiving cavity 2010. For example, the width L1 is 0.45 mm, 0.5 mm, 0.55 mm, 0.6 mm or 0.8 mm.

In this way, on the one hand, there is sufficient adhesive in the adhesive receiving groove 210, making the adhesive have a sufficient sealing or fixing effect, on the other hand, on a basis that a receiving volume of the adhesive receiving groove 210 is able to hold sufficient adhesive, as the adhesive receiving gap 2003 is connected to the adhesive receiving groove 210, a small amount of adhesive is allowed to overflow into the adhesive receiving gap 2003, which further seals between the housing 201 and the housing 202, thereby enhancing a sealing performance, and as the adhesive receiving gap 2003 is able to retain the adhesive, it relives a risk of the adhesive further oozing out to the outer surface of the housing 201 in an excessive manner.

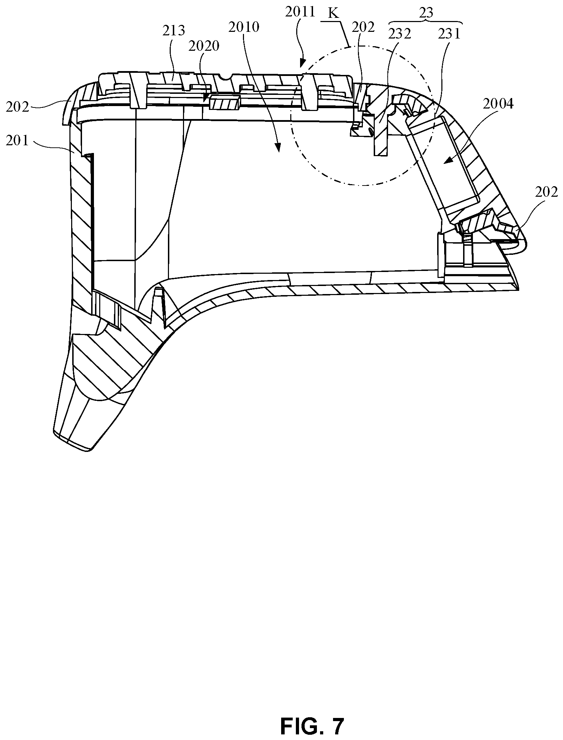

As shown in FIG. 3 and FIG. 7, the housing 201 is further disposed with an accommodation groove 2004 that is connected to the receiving cavity 2010. The headphone 100 further includes an interface assembly 22 inserted into the accommodation groove 2004, and the housing 202 is disposed to partially cover the interface assembly 22.

The interface assembly 22 may be configured to connect to an external power source to charge the headphone 100. The interface assembly 22 may also be configured to connect an external device to transfer data between the external device and the headphone 100. For example, the interface assembly 22 is a Type-C interface or other types of interfaces, such as a mini-USB interface. In some embodiments, the interface assembly 22 is connected to the circuit board 28 within the receiving cavity 2010. The external device or the external power sources are connected to the interface assembly 22 through the accommodation groove 2004.

By disposing the housing 202 to partially shield the interface assembly 22, the housing 202 is able to stop the interface assembly 22, which limits the movement of the interface assembly 22 outwardly towards the housing 202 in the direction away from the receiving cavity 2010, which is conducive to a structural stability of the headphone 100, and at the same time facilitates the assembly of the interface assembly 22.

As shown in FIG. 3, FIG. 7, and FIG. 8, the headphone 100 further includes a dust plug 23, the dust plug 23 includes a plug body 231 and a fixing portion 232. The fixing portion 232 is disposed on the housing 201 between the key assembly 21 and the interface assembly 22 through the housing 202, and the plug body 231 is connected to the fixing portion 232 and is configured to selectively shield the interface assembly 22.

The dust plug 23 protects the interface assembly 22 when it shields the interface assembly 22, for example, the dust plug 23 may keep water and dust away from the interface assembly 22, and also reduce a risk of mechanical damage to the interface assembly 22.

In some embodiments, the dust plug 23 has a deformation capability, and according to the deformation of the dust plug 23, the plug body 231 and the fixing portion 232 move relative to each other. By moving relative to the fixing portion 232, the plug body 231 may be switchable between shielding the interface assembly 22 and not shielding the interface assembly 22. Specifically, the plug body 231 may form a shield against the interface assembly 22 by being inserted into the accommodation groove 2004.

As shown in FIG. 7, the fixing portion 232 may extend through the housing 202 and onto the housing 201 between the key assembly 21 and the interface assembly 22, thereby reducing a space taken up by the fixing portion 232 on an outer surface of the housing 202 to improve a space utilization. Specifically, the fixing portion 232 may have a recess 2321, and the housing 202 may be provided with a through hole 202a, through which the fixing portion 232 is threaded through the housing 202. A hole wall of the through hole 202a may be snapped into the recess 2321, and thus limited within the recess 2321, such that a bottom wall of the recess 2321 is disposed relative to the hole wall of the through hole 202a, which limits a relative movement between the housing 202 and the fixing portion 232.

The dust plug 23 may be prepared of an elastic material, such as silicone, rubber, etc., so as to facilitate the insertion of the plug body 231 into the accommodation groove 2004, and to facilitate the threading of the fixing portion 232 through the housing 202, and at the same time to make the dust plug 23 deformable.

As shown in FIGs. 9-11, the earhook assembly 2 may include a housing assembly 26. The housing assembly 26 includes a housing 261 and a housing 262 that cooperate with each other, with an adhesive receiving groove 2601 disposed in a first of the housing 261 and the housing 262. The adhesive receiving groove 2601 includes at least a first sidewall 2602 near an interior of the housing assembly 26, a second sidewall 2603 away from the interior of the housing assembly 26, and a bottom wall connecting the first sidewall 2602 and the second sidewall 2603. A second of the housing 261 and the housing 262 is inserted into the adhesive receiving groove 2601 to form a first gap 2604 with the first sidewall 2602 and form a second gap 2603 with the second sidewall 2603. A width L2 of the first gap 2604 is greater than a width L3 of the second gap 2605 in a spacing direction between the first sidewall 2602 and the second sidewall 2603. The housing 261 is also referred to as a first housing, and the housing 262 is also referred to as the second housing.

For example, the housing 262 is provided with the adhesive receiving groove 2601, and the housing 261 is inserted into the adhesive receiving groove 2601.

The housing 261 and the housing 262 may be connected to form a receiving cavity 2600 between the housing 261 and the housing 262. The receiving cavity 2600 may be configured to accommodate components of the headphone 100, such as the battery 29. The battery 29 may be configured to power the headphone 100.

In some embodiments, as shown in FIG. 4, the circuit board 28 may be disposed in the receiving cavity 2600. The circuit board 28 is configured for converting and processing electrical signals to support the implementation of various functions of the headphone 100, for example, the circuit board 28 supports the headphone 100 to implement functions such as switching on and off, switching playback contents, increasing and decreasing the sound volume, etc. In some embodiments, the two earhook assemblies 2 include the housing assembly 20 and the housing assembly 26, one of which is disposed with the battery 29, and the other is disposed with the circuit board 28.

The adhesive may be disposed between the housing 261 and the housing 262. The adhesive may form a sealing between the housing 262 and the housing 261 to improve the waterproof performance of the headphone 100. The adhesive may also act as a fixation by adhering. When dispensing adhesive, the adhesive may be in a form of a fluid, and the adhesive may cure after a period of time.

The adhesive receiving groove 2601 may be configured to hold the adhesive. The dispensing operation of the adhesive is facilitated by setting the adhesive receiving groove 2601 to be exposed externally along the insertion direction of the second of the housing 261 and the housing 262. By disposing the adhesive receiving groove 2601, it is convenient to control a dispensing amount when dispensing the adhesive into the adhesive receiving groove 2601, thereby reducing a risk of the headphone 100 being poorly sealed due to a low dispensing amount of adhesive. At the same time, a probability of the adhesive seeping outwardly onto the outer surfaces of the housing 261 and the housing 262 or seeping inwardly into the receiving cavity 2600 due to too much dispensing of the adhesive may also be reduced, so as to minimize the adverse effect on the operation state and the appearance of the headphone 100.

The dispensing of the adhesive may be performed first during the assembly process, and then the second of the housing 261 and the housing 262 may be inserted into the adhesive receiving groove 2601 such that the adhesive fills the first gap 2604 and the second gap 2605, respectively. By disposing the width L2 of the first gap 2604 greater than the width L3 of the second gap 2605 so that the second gap 2605 is able to hold more adhesive, when the second of the housing 261 and the housing 262 is inserted into the adhesive receiving groove 2601, the adhesive tends to flow into the second gap 2605, thereby reducing the probability of the adhesive flowing onto the outer surfaces of the housing 261 and the housing 262, which is conducive to maintaining a good appearance of the headphone 100.

In some embodiments, the second of the housing 261 and the housing 262 has a connection boss 2609 inserted within the adhesive receiving groove 2601.

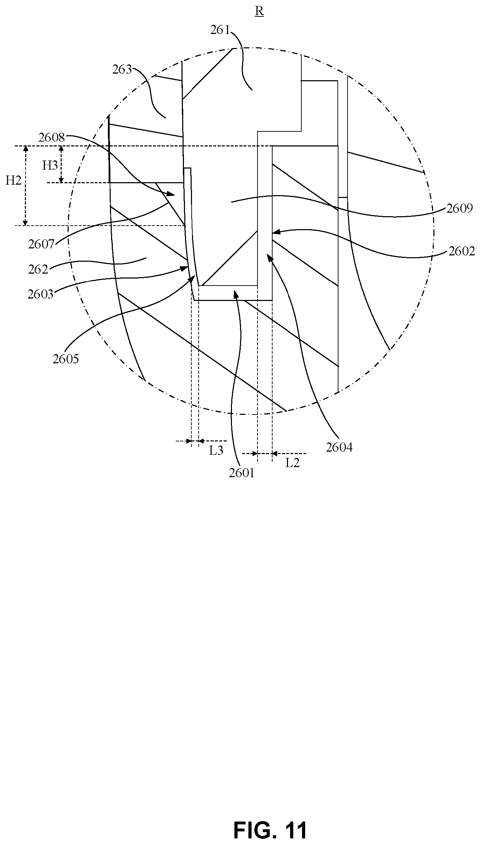

As shown in FIGs. 11-13, a positioning rib 2606 is disposed on the first sidewall 2602 and/or the second sidewall 2603, and the positioning rib 2606 is configured to define widths of the first gap 2604 and the second gap 2605. For example, the positioning rib 2606 is disposed on the first sidewall 2602. In a spaced apart direction of the first sidewall 2602 and the second sidewall 2603, the positioning rib 2606 may impede the second of the housing 261 and the housing 262 from contacting the first sidewall 2602. When the second of the housing 261 and the housing 262 abuts against the positioning rib 2606, a projection height of the positioning rib 2606 may be taken as the width L2 of the first gap 2604. When the second of the housing 261 and the housing 262 does not abut the positioning rib 2606, the width L2 of the first gap 2604 is greater than the projection height of the positioning rib 2606. Furthermore, at a design stage of the housing assembly 26, in the spacing direction of the first sidewall 2602 and the second sidewall 2603, the width L2 of the first gap 2604 is set greater than or equal to the positioning rib 2606, and the width L3 of the second gap 2605 is set to be less than the projection height of the positioning rib 2606, such that the width L2 of the first gap 2604 is greater than the width L3 of the second gap 2605.

As another example, the positioning rib 2606 is disposed on the second sidewall 2603. In the design stage of the housing assembly 26, in the spacing direction of the first sidewall 2602 and the second sidewall 2603, the width L3 of the second gap 2605 is disposed equal to the projection height of the positioning rib 2606, and the width L2 of the first gap 2604 is disposed greater than the projection height of the positioning rib 2606, such that the width L2 of the first gap 2604 is greater than the width L3 of the second gap 2605. During the assembly process of inserting the second of the housing 261 and the housing 262 into the adhesive receiving groove 2601, it is necessary to keep the second of the housing 261 and the housing 262 abut against the positioning rib 2606 so that the width L3 of the second gap 2605 is equal to the projection height of the positioning rib 2606, such that the width L3 of the second gap 2605 is less than the width L2 of the first gap 2604.

As another example, the first sidewall 2602 and the second sidewall 2603 are each disposed with the positioning rib 2606, and in the spacing direction of the first sidewall 2602 and the second sidewall 2603, the projection height of the positioning rib 2606 on the first sidewall 2602 is greater than the projection height of the positioning rib 2606 on the second sidewall 2603. During the assembly process of inserting the second of the housing 261 and the housing 262 into the adhesive receiving groove 2601, the second of the housing 261 and the housing 262 needs to be kept in contact with the positioning rib 2606 on the second sidewall 2603, so that the width L2 of the first gap 2604 is greater than the width L3 of the second gap 2605.

In some embodiments, there are two or more spaced apart positioning ribs 2606.

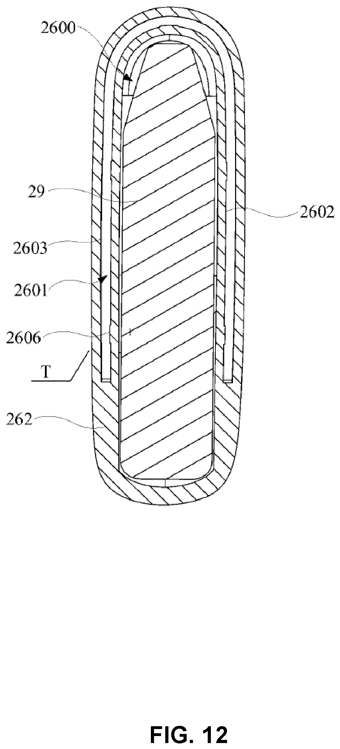

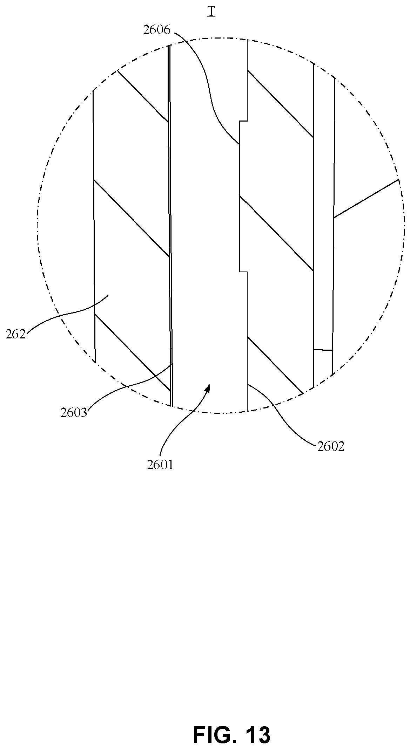

In some embodiments, combining FIG. 12 and FIG. 13, the positioning rib 2606 is disposed on the first sidewall 2602.

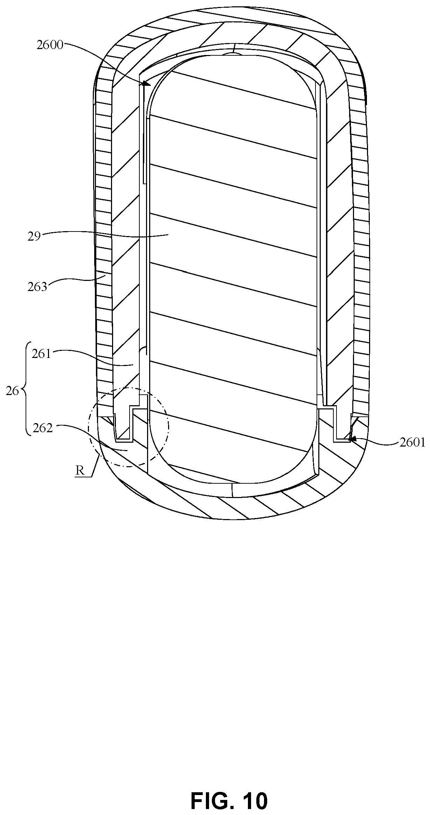

In some embodiments, combining FIG. 10 and FIG. 11, a difference between the width L2 of the first gap 2604 and the width L3 of the second gap 2605 is greater than or equal to 0.05 mm. For example, the difference between the width L2 of the first gap 2604 and the width L3 of the second gap 2605 is 0.06 mm, 0.07 mm, 0.08 mm, 0.09 mm, or 0.1 mm.

In this way, the amount of adhesive flowing to the second gap 2605 during insertions of the second of the housing 261 and the housing 262 into the adhesive receiving groove 2601 is within an acceptable range, which, in turn, prevents the adhesive from flowing onto the housing 261 and the outer surface of the housing 262.

As the height of the different positions of the first gap 2604 relative to the bottom wall of the adhesive receiving groove 2601 changes, the width L2 of the first gap 2604 may change. As the height of the different positions of the second gap 2605 relative to the bottom wall of the adhesive receiving groove 2601 changes, the width L3 of the second gap 2605 may change. Therefore, there is a need to compare the width L2 of the first gap 2604 and the width L3 of the second gap 2605 at the same height relative to the bottom wall of the adhesive receiving groove 2601 as well as to determine a difference between the width of the first gap 2604 L2 and the width L3 of the second gap 2605.

As shown in FIG. 10 and FIG. 11, in the insertion direction of the housing 261 and the housing 262, the height of the end of the first gap 2604 away from the bottom wall relative to the bottom wall is greater than the height of the end of the second gap 2605 away from the bottom wall relative to the bottom wall.

The first gap 2604 has a greater width compared to the second gap 2605, and the adhesive tends to flow into the first gap 2604. By setting the height of the end of the first gap 2604 away from the bottom wall relative to the bottom wall to be greater than the height of the end of the second gap 2605 away from the bottom wall relative to the bottom wall, it may be possible to make the first gap 2604 capable of holding more adhesive, thereby reducing the probability of the adhesive flowing through the first gap 2604 into the interior of the housing assembly 26.

In some embodiments, combining FIG. 10 and FIG. 11, a height difference H2 between the end of the first gap 2604 away from the bottom wall and the end of the second gap 2605 away from the bottom wall is greater than or equal to 0.5 mm. For example, the height difference H2 between the end of the first gap 2604 away from the bottom wall and the end of the second gap 2605 away from the bottom wall is 0.6 mm, 0.7 mm, 0.8 mm, 0.9 mm, or 1 mm.

In this way, the first gap 2604 is made to hold more adhesive compared to the second gap 2605 during the insertions of the second of the housing 261 and the housing 262 into the adhesive receiving groove 2601 so that more adhesive flows toward the first gap 2064 during squeezing, and the amount of adhesive flowing through the second gap 2604 toward the interior of the housing assembly 26 is within an acceptable range, or the adhesive may not flow toward the interior of the housing assembly 26.

As shown in FIG. 10 and FIG. 11, the adhesive receiving groove 2601 includes a third sidewall 2607 connected to the first sidewall 2602, and the third sidewall 2607 is far from the bottom wall of the adhesive receiving groove 2601 as compared to the first sidewall 2602. A third gap 2608 is formed between the third sidewall 2607 and the second of the housing 261 and the housing 262, with a width of the third gap 2608 gradually increasing in a spacing direction away from the bottom wall. For example, the third sidewall 2607 is disposed in the housing 262 and forms a third gap 2608 between the housing 262 and the housing 261.

The third gap 2608 is configured to accommodate the adhesive overflow from the second gap 2605 when more adhesive flows into the second gap 2605 and overflows from the second gap 2605. By disposing the third gap 2608, the risk of adhesive flowing from the second gap 2605 onto the outer surfaces of the housing 261 and the housing 262 may be reduced.

In the spacing direction, by setting the width of the third gap 2608 to gradually increase in the direction away from the bottom wall of the adhesive receiving groove 2601, the amount of adhesive held by the third gap 2608 may be increased, thereby further reducing the risk of adhesive flowing onto the housing 261 and the outer surface of the housing 262.

In some embodiments, the third sidewall 2607 may also guide during the insertions of the second of the housing 261 and the housing 262 into the adhesive receiving groove 2601, thereby facilitating the insertions of the second of the housing 261 and the housing 262 into the adhesive receiving groove 2601 and improving the assembly efficiency.

A portion of the third gap 2608 may have a width greater than the width L2 of the first gap 2604, as shown in FIG. 10 and FIG. 11.

The width of the portion of the third gap 2608 near the bottom wall of the adhesive receiving groove 2601 is smaller, thereby reducing the amount of adhesive that the third gap 2608 is able to hold. By setting the width of the portion of the third gap 2608 that is away from the bottom wall of the adhesive receiving groove 2601 to be greater than the width L2 of the first gap 2604, the amount of the adhesive held by the third gap 2608 may be increased, thereby reducing the risk of the adhesive flowing onto the outer surfaces of the housing 261 and the housing 262.

As shown in FIG. 10 and FIG. 11, a height of the end of the first gap 2604 away from the bottom wall of the adhesive receiving groove 2601 relative to the bottom wall of the adhesive receiving groove 2601 is greater than a height of the end of the third gap 2608 away from the bottom wall of the adhesive receiving groove 2601 relative to the bottom wall of the adhesive receiving groove 2601, i.e., there is a height difference H3.

By setting the height of the end of the first gap 2604 away from the bottom wall of the adhesive receiving groove 2601 relative to the bottom wall of the adhesive receiving groove 2601 to be greater than the height of the end of the third gap 2608 away from the bottom wall of the adhesive receiving groove 2601 relative to the bottom wall of the adhesive receiving groove 2601, it is possible to enable the first gap 2604 to hold more adhesive, thereby reducing the probability of the adhesive flowing to the interior of the housing assembly 26.

On the other hand, the first sidewall 2602 may act as a limit. Specifically, the third gap 2608 may act as a guide, and during the insertions of the second of the housing 261 and the housing 262 into the adhesive receiving groove 2601, the second of the housing 261 and the housing 262 moves toward the first sidewall 2602. By setting the height of the end of the first gap 2604 away from the bottom wall relative to the bottom wall to be greater than the height of the end of the third gap 2608 away from the bottom wall relative to the bottom wall, when the second in the housing 261 and the housing 262 move toward the first sidewall 2602, the first side wall 2602 may play a limiting role, so that the second in the housing 261 and the housing 262 is inserted smoothly into the adhesive receiving groove 2601, and the assembly efficiency may be improved.

As shown in FIG. 10 and FIG. 11, the housing assembly 26 may include an elastic wrapping layer 263 partially wrapped on an outer surface of the housing 261, the adhesive receiving groove 2601 is disposed in the housing 262, and an exposed portion of the housing 261 that is not wrapped by the elastic wrapping layer 263 is inserted into the adhesive receiving groove 2601.

Specifically, the exposed portion of the housing 261 not wrapped by the elastic wrapping layer 263 may be the connection boss 2609.

By disposing the elastic wrapping layer 263 on the outer surface of the housing 261, the comfort of the user when holding the headphone 100 is improved, and the friction is increased.

By inserting the exposed portion of the housing 261 into the adhesive receiving groove 2601, the housing 261 may position the housing 262, which limits the relative movement of the housing 261 and the housing 262, and increases a stability of the connection between the housing 261 and the housing 262.

By setting the exposed portion of the housing 261 to be wrapped by the elastic wrapping layer 263, an interference of the elastic wrapping layer 263 on the connection between the housing 261 and the housing 262 within the adhesive receiving groove 2601 may be avoided.

In some embodiments, the housing 262 is abut against the elastic wrapping layer 263 along the insertion direction of the exposed portion relative to the housing 262, which makes the outer surface of the housing 262 and the outer surface of the elastic wrapping layer 263 to be flush at an offset point, which on the one hand makes the housing 262 and the elastic wrapping layer 263 closer at the offset point, provides a better sealing effect, reduces the entry of the debris and the water vapor, and improves a service life of the elastic wrapping layer 263, and on the other hand, the flush at the offset reduces the discomfort to the user when being touched, which makes the headphone 100 more integrative and more comfortable, and also more aesthetically pleasing.

In some embodiments, the housing 262 is not wrapped by the elastic wrapping layer 263, and an outer surface area of the housing 262 may be smaller than an outer surface area of the housing 261, and the user tends to hold the housing 261 to hold the headphone 100, such that the outer surface of the housing 262 may not be disposed with the elastic wrapping layer 263.

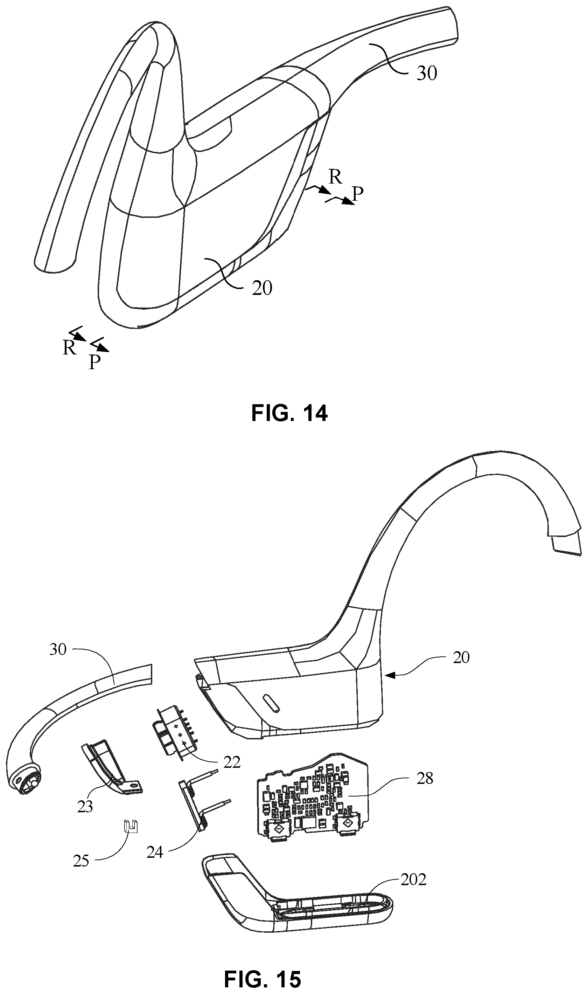

As shown in FIG. 14 and FIG. 15, the earhook assembly 2 may include the housing assembly 20, an interface assembly 22, a stopper 25, the circuit board 28, and the lead assembly 24. In some embodiments, the headphone 100 may also include a wearing assembly 30 and the dust plug 23.

In some embodiments, as shown in FIGs. 15-18, the housing assembly 20 includes the housing 201 disposed with the accommodation groove 2004 and the receiving cavity 2010 connected to the accommodation groove 2004. The interface assembly 22 is inserted into the accommodation groove 2004. The circuit board 28 is disposed within the receiving cavity 2010. The lead assembly 24 electrically connects the circuit board 28 to the interface assembly 22.

By disposing the interface assembly 22 and the circuit board 28 separately instead of fixing and soldering the interface assembly 22 directly to the circuit board 28, the lead assembly 24 is configured to connect the interface assembly 22 and the circuit board 28. In this way, a degree of freedom of a mounting position and a mounting attitude of the interface assembly 22 is improved. On this basis, the accommodation groove 2004 and the receiving cavity 2010 connected with the accommodation groove 2004 are reasonably disposed inside the housing 201 for holding the interface assembly 22 and the circuit board 28, respectively, which is favorable to a flexible application of the space inside the housing 201 to mount the interface assembly 22 and the circuit board 28 respectively, thereby facilitating the assembly of the headphone 100.

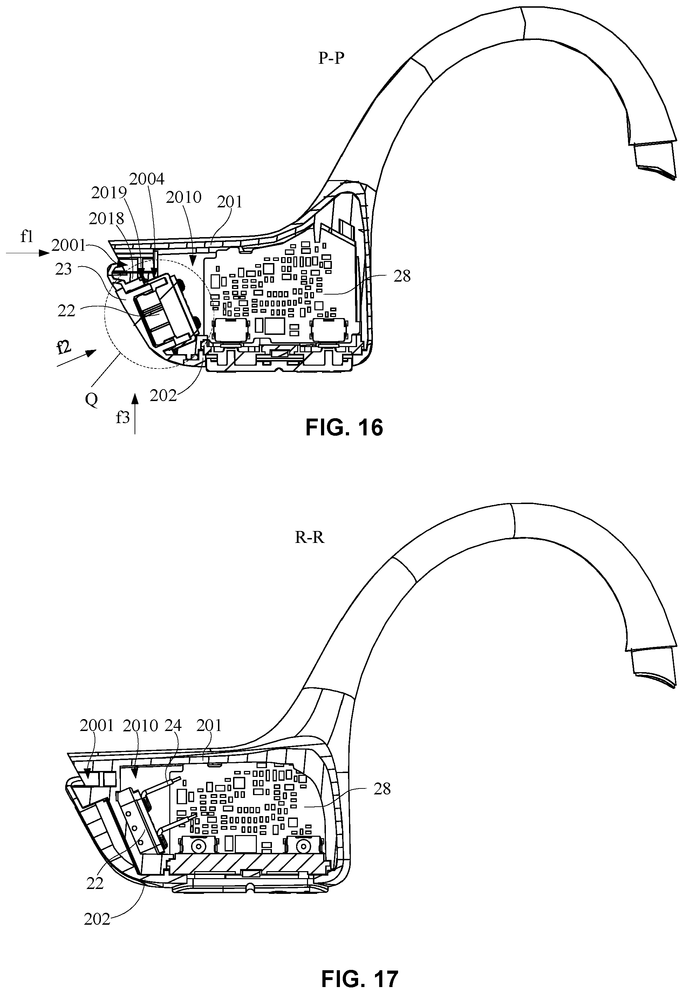

As shown in FIG. 16, the circuit board 28 is spaced apart from the interface assembly 22 in an insertion direction f2 of the interface assembly 22 relative to the accommodation groove 2004.

By maintaining a certain spacing between the interface assembly 22 and the circuit board 28 in the insertion direction f2 of the interface assembly 22 relative to the accommodation groove 2004, the interface assembly 22 effectively reduces an encroachment on a space of the receiving cavity 2010 where the circuit board 28 is located, which effectively reduces a possibility of the interface assembly 22 interfering with the circuit board 28, improves an effectiveness of the operation of the interface assembly 22 and the circuit board 28, and improves the reliability and the service life of the headphone 100.

In some embodiments, as shown in FIGs.16-19, the housing 201 is disposed with an insert groove 2001 spaced apart from the accommodation groove 2004 by an interval wall 2018. The interval wall 2018 is disposed with a connection groove 2019 connecting the insert groove 2001 and the accommodation groove 2004. The wearing assembly 30 includes an insert member 33, the insert member 33 comprising an insert body 331 inserted within the insert groove 2001. The stopper 25 is disposed to be able to be inserted into the insert groove 2001 from the accommodation groove 2004 through the connection groove 2019 and is configured for snapping the insert body 331 into the insert groove 2001. The interface assembly 22 is inserted into the accommodation groove 2004.

By disposing the interval wall 2018 to form the insert groove 2001 and the accommodation groove 2004 isolated from each other, and configured for the insertion of the insert member 33 and the interface assembly 22, respectively, while the insert member 33 and the interface assembly 22 are effectively limited and mounted, the insert member 33 and the interface assembly 22 do not interfere with each other, and do not encroach on the space of each other, which are convenient for assemble and disassemble, and are conducive to a maintenance and care of the headphone 100. The connection groove 2019 disposed on the interval wall 2018 is configured for the insertion of the stopper 25 to stop the insert body 331 into the insert groove 2001, so that the stopper 25 limits the insert body 331 when not exposed outside the housing 201. In this way, the stability and reliability of the mounting of the insert body 331 is improved without affecting the appearance of the headphone 100, which effectively improves the aesthetics of the headphone 100. In addition, disposing the connection groove 2019 in the interval wall 2018 may improve a utilization rate of the space, realize a close arrangement inside the housing assembly 20, and reduce the volume of the headphone 100.

In some embodiments, a rear end portion of the housing assembly 20 (i.e., an end portion disposed with a groove opening of the insert groove 2001 and a groove opening of the accommodation groove 2004, which away from the ear in the wearing state) is inclined, which, on the one hand, is designed to reduce the volume and a weight of the entire housing assembly 2 and make the entire headphone 100 miniaturized, and on the other hand, makes it easy for mold opening and demolding, thereby reducing a manufacturing difficulty, and making the headphone 100 more aesthetically pleasing. By setting the interface assembly 22 at the inclined rear end portion, a slope region which is not easy to be utilized may be efficiently utilized, and an overall structure may be more compact, and the space utilization may be high. Additionally, the interface assembly 22 is disposed at the rear end portion instead of a lower side surface, which has less impact on the stability of a placement of the headphone when in use. Additionally, cables connecting to the interface assembly 22 are less likely to wobble with the interface assembly 22 and rub unnecessarily against each other, and the cables are less likely to rub against the region where they are placed.

In some embodiments, the interface assembly 22 and the housing 202 are fixed by dispensing adhesive to achieve a fixation between the interface assembly 22 and the housing 202 as well as a fixation and sealing of a connection position between the interface assembly 22 and the housing 202. In some embodiments, the interface assembly 22 and the housing 202 are fixed by disposing a silicone member (not shown in the figure). The silicone member is interference fit with the interface assembly 22 and the housing 202, and the interface assembly 22 and the housing 202 are fixed through snap screws and other fixing structures, so as to realize the fixing between the interface assembly 22 and the housing 202 as well as the fixing and sealing between the interface assembly 22 and the connecting position of the housing 202.

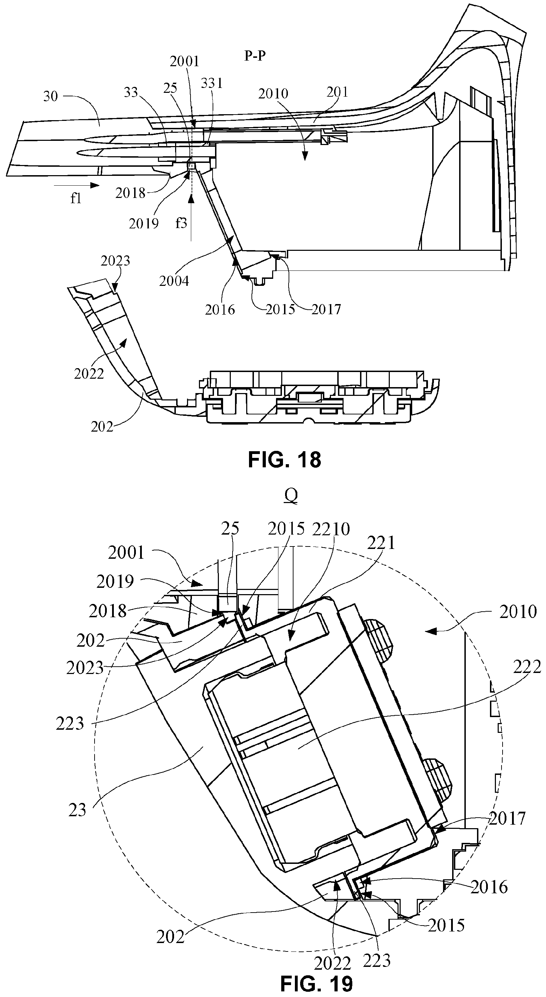

In some embodiments, as shown in FIG. 18, the position of the connection groove 2019 is set such that the stopper 25 is visible from an exterior of the housing 201 in an insertion direction f3 along the stopper 25 relative to the connection groove 2019.

The connection groove 2019 is visible from the exterior of the housing 201, i.e., the position of the connection groove 2019 is clearly exposed to the exterior of the housing 201, so that when inserted along the insertion direction f3 of the stopper 25 relative to the connection groove 2019, the stopper 25 has a clear position, and is able to operate easily, so as to effectively reduce the assembly difficulty and facilitate assembly and disassembly.

In some embodiments, as shown in FIGs. 16-18, the housing assembly 20 further includes the housing 202, which is connected to the housing 201 and is configured to shield the connection groove 2019 and the stopper 25.

The connection between the housing 202 and the housing 201 may shield the connection groove 2019 and the stopper 25 to make the connection groove 2019 and the stopper 25 invisible from the outside of the headphone 100, thereby improving the aesthetics of the headphone 100. Compared to an integrated housing, the provision of the split-connected housing 201 and the housing 202 allows the mounting of the stopper 25 when the housing 202 is not connected to the housing 201, which is easy to operate and less difficult to install. After inserting the stopper 25, by connecting the housing 202 and the housing 201, the connection groove 2019 and the stopper 25 may be shielded, which ensures that the headphone 100 assembly is operable and effectively safeguards the aesthetics of the headphone 100.

In some embodiments, as shown in FIG. 16 and FIG. 19, the housing 202 is further disposed to be capable of stopping the stopper 25 in an opposite direction of the insertion direction f3 of the stopper 25 relative to the connection groove 2019.

The housing 202, while shielding the connection groove 2019 and the stopper 25, is able to stop the stopper 25 to support the stopper 25, thereby avoiding that the stopper 25 from moving in the opposite direction of the direction f3, which causes the insert member 33 to loosen and affect the use of the headphone 100. In this way, the stability of the connection is enhanced, and the service life of the headphone 100 is improved.

In some embodiments, as shown in FIG. 18 and FIG. 19, the interface assembly 22 includes a main body portion 221 and a wire arrangement portion 222. The main body portion 221 is provided with a first guiding cavity 2210, and the wire arrangement portion 222 is disposed within the first guiding cavity 2210. The housing 202 is disposed with a second guiding cavity 2022, the housing 202 is connected to the housing 201, and the second guiding cavity 2022 is connected to the first guiding cavity 2210.

By connecting the housing 202 to the housing 201 to enable the first guiding cavity 2210 and the second guiding cavity 2022 to connect to each other, the interface assembly 22 does not need to set up a complete guiding cavity for the wire arrangement portion 222, and the second guiding cavity 2022 is constructed using the housing 202, which reduces the overall volume of the housing assembly 20 and makes the housing assembly 20 more compact.

The wire arrangement portion 222 protrudes from the first guiding cavity 2210 and extends into the second guiding cavity 2022. In the above way, the first guiding cavity 2210 and the second guiding cavity 2022 are made to collectively accommodate the wire arrangement portion 222 to facilitate a plug of the wire arrangement portion 222.

As shown in FIG. 19, the interface assembly 22 may further include a flange portion 223 disposed on a side of the main body portion 221 away from the receiving cavity 2010. The housing 201 is disposed with a first support platform 2015, the flange portion 223 is supported on the first support platform 2015, and the housing 202 is disposed to shield the flange portion 223.

By disposing the flange portion 223 supported on the first support platform 2015, the support of the flange portion 223 by the first support platform 2015 may improve the stability and reliability of the mounting of the interface assembly 22, so as to effectively limit and mount the interface assembly 22. Additionally, the housing 202 is disposed to shield the flange portion 223, and the flange portion 223 is not exposed to the exterior of the housing assembly 20, so that the flange portion 223 is invisible by the user from the exterior of the headphone 100, which effectively enhances the aesthetics of the headphone 100.

As shown in FIG. 19, the housing 202 may further press the flange portion 223 against the first support platform 2015.

The flange portion 223 is pressed by the housing 202 against the first support platform 2015, thereby making the flange portion 223 to be tightly supported against the first support platform 2015, improving a support effect of the first support platform 2015 on the flange portion 223, and further making the housing assembly 20 more stable and reliable for the limiting and mounting of the interface assembly 22. In this way, the possibility of a shaking of the interface assembly 22 is reduced, and the fixing effect is effectively improved.

As shown in FIG. 19, the first support platform 2015 is disposed with an adhesive receiving groove 2016, and the flange portion 223 covers the adhesive receiving groove 2016.

The adhesive receiving groove 2016 may hold the adhesive, so that when the interface assembly 22 is mounted, the adhesive held in the adhesive receiving groove 2016 may fill a gap between the interface assembly 22 and the housing 201, thereby improving the sealing. The use of the sealant may effectively fix the interface assembly 22, and increase the stability of the connection between the interface assembly 22 and the housing 201.

As shown in FIG. 18 and FIG. 19, the first support platform 2015, the flange portion 223, and the adhesive receiving groove 2016 are set to be closely surround the accommodation groove 2004 around the interface assembly 22 relative to the insertion direction f2 of the accommodation groove 2004.

The first support platform 2015, the flange portion 223, and the adhesive receiving groove 2016 are all closely surround the containment groove 2004 around the interface assembly 22, i.e., the flange portion 223 is supported on the first support platform 2015 around the interface assembly 22, which effectively improves a contact area between the first support platform 2015 and the flange portion 223, and makes a support force provided by the first support platform 2015 to the interface assembly 22 uniform and reliable, thereby effectively improving the support effect of the first support platform 2015 on the interface assembly 22, improving the fixing effect, and improving the service life of the headphone 100. Additionally, the adhesive receiving groove 2016 that closely surrounds the accommodation groove 2004 around the interface assembly 22 allows for a complete dispensing of the adhesive around the accommodation groove 2004 when the interface assembly 22 is installed, thereby effectively improving the sealing effect.

In some embodiments, combining FIG. 18 and FIG. 19, the housing 201 is further disposed with a second support platform 2017, and an inner end surface of a side of the main body portion 221 towards the receiving cavity 2010 is supported on the second support platform 2017.

By setting the second support platform 2017 to support the inner end surface of the side of the main body portion 221 towards the receiving cavity 2010, the first support platform 2015 and the second support platform 2017 jointly support the interface assembly 22 to improve the stability of the interface assembly 22, and reduce the possibility of shaking of the interface assembly 22.

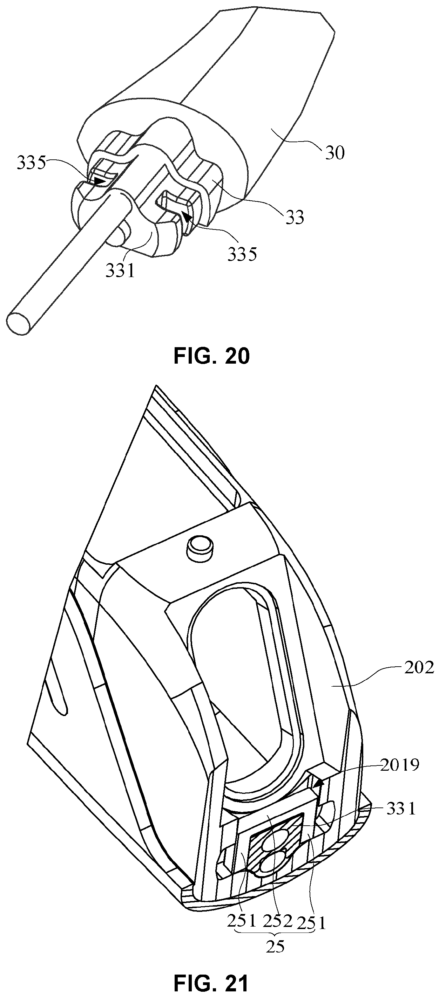

In some embodiments, as shown in FIG. 20 and FIG. 21, the stopper 25 includes two insert pins 251 disposed side-by-side and a connection portion 252 connecting the two insert pins 251. The insert body 331 is disposed with two slots 335, the two pins 251 are respectively inserted into the two slots 335, and the connection portion 252 is disposed in the connection groove 2019 and forms an interference with a groove wall of the connection groove 2019 at least in the opposite direction of the insertion direction f1.

The stopper 25 is configured to stop and limit the insert body 331 to realize the limiting and mounting of the insert member 33, and by disposing two pins 251 side by side in the stopper 25, and by making the insert body 331 disposed with two slots 335 that cooperate with the two pins 251 to connect the stopper 25 and the insert body 331, the two pins 251 may be correspondingly inserted in the two slots 335, and the two pins 251 may improve the connection stability and improve the effect of the stop.

The connection portion 252 is disposed in the connection groove 2019, and the connection portion 252 forms the interference with the groove wall of the connection groove 2019 at least in the opposite direction of the insertion direction f1, so as to make the slot wall of the connection groove 2019 provide a supporting force to the connection portion 252, which in turn reduces an overall height of the stopper 25 and improves the stability and reliability of the connection.

As shown in FIG. 19 and FIG. 21, the connection portion 252 may be sunk in the connection groove 2019, and the housing 202 may be disposed with an adhesive receiving groove 2023 connected to the connection groove 2019.

The adhesive receiving groove 2023 may hold the sealant, so that when the housing 202 is mounted, the sealant held in the adhesive receiving groove 2023 may fill the gap between, for example, the housing 202 and the connection groove 2019, and the gap between the housing 202 and the connection portion 252, to improve the sealing. The use of the sealant effectively fixes the stopper 25 and the housing 202, increasing the stability of the connection between the housing 201, the housing 202, and the stopper 25.

In some embodiments, as shown in FIG. 19, the interval wall 2018 is further disposed with the first support platform 2015. The flange portion 223 is supported on the first support platform 2015.

By disposing the flange portion 223 and the support platform 2015, and by supporting the flange portion 223 on the first support platform 2015, the support of the flange portion 223 by the support platform 2015 is able to improve the stability and reliability of the mounting of the interface assembly 22, and effectively limiting and mounting the interface assembly 22.

As shown in FIG. 19, the flange portion 223 may be further disposed to be capable of stopping the stopper 25 in the opposite direction of the insertion direction f3.

By disposing the flange portion 223 to stop the stopper 25 in the opposite direction of the insertion direction f3, a supporting force is further provided for the stopper 25 to stop and limit the stopper 25. In this way, the structure of the headphone 100 is made more stable and solid, the possibility of shaking and loosening of the stopper 25 is reduced, and the service life of the headphone 100 is increased.

In some embodiments, as shown in FIG. 16, the insertion direction f2 is set at an acute angle to the insertion direction f1. Specifically, the insertion direction f1 is disposed at an acute angle to the insertion direction f2. The second support platform 2017 is disposed on a side of the interface assembly 22 away from the insert member 33, and an inner end surface of the main body portion 221 is suspended on the side of the body portion 221 towards the insert member 33.

On the basis that the insertion direction f2 is set at the acute angle to the insertion direction f1, a side of an inner end surface of the main body portion 221 is supported on the second support platform 2017, and a side towards the insert member 33 is suspended, which reduces the volume of the housing assembly 20 and improves the space utilization inside the housing assembly 20 while effectively supporting and fixing the interface assembly 22.

In some embodiments, as shown in FIG. 16, a side of the interface assembly 22 towards the interior of the housing 201 is disposed to exceed the interval wall 2018 in the insertion direction f2.

On the basis that the insertion direction f2 is set at the acute angle to the insertion direction f1, the interface assembly 22 exceeds the interval wall 2018, so as to further make full use of the space inside the housing assembly 20 without interference between the interface assembly 22 and the insert body 331, and to improve the space utilization inside the housing assembly 20, and make the structure inside the housing assembly 20 more compact, improve an integrality and a tightness of the structure, reduce volumes of the housing assembly 20 and the headphone 100, make the headphone 100 more convenient to wear and carry, and enhance a sense of use of the headphone 100.

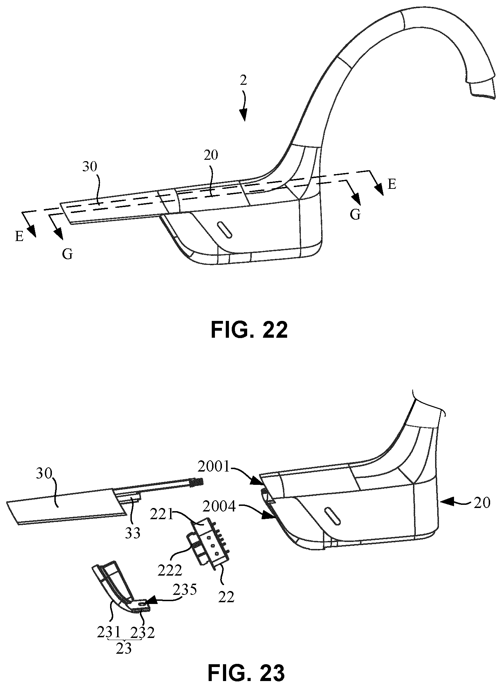

The interface assembly 22 is inserted in the accommodation groove 2004 as shown in FIGs. 22-24. The interface assembly 22 is configured for a corresponding external interface to be plugged in to enable the headphone 100 to electrically connect to other devices for functions such as charging, transmission, etc. The dust plug 23 may be partially fixed to the housing assembly 20 through the cooperation between the housing 201 and the housing 202, and may selectively shield the interface assembly 22.

In some embodiments, the wearing assembly 30 may include the insert member 33. The insert member 33 may be inserted into the housing assembly 20 to enable the wearing assembly 30 to be fixed to the housing 201. The wearing assembly 30 is configured to be worn on an auricle, the neck, the back of the head, etc., to fix the headphone 100 at a certain position.

In some embodiments, as shown in FIGs. 23 to FIG. 24, the headphone 100 further includes the key assembly 21 disposed within the housing 201 and exposed through the housing 202, and specifically, the key assembly 21 is configured to be operated by the user for realizing a human-machine interaction function between the headphone 100 and the user.

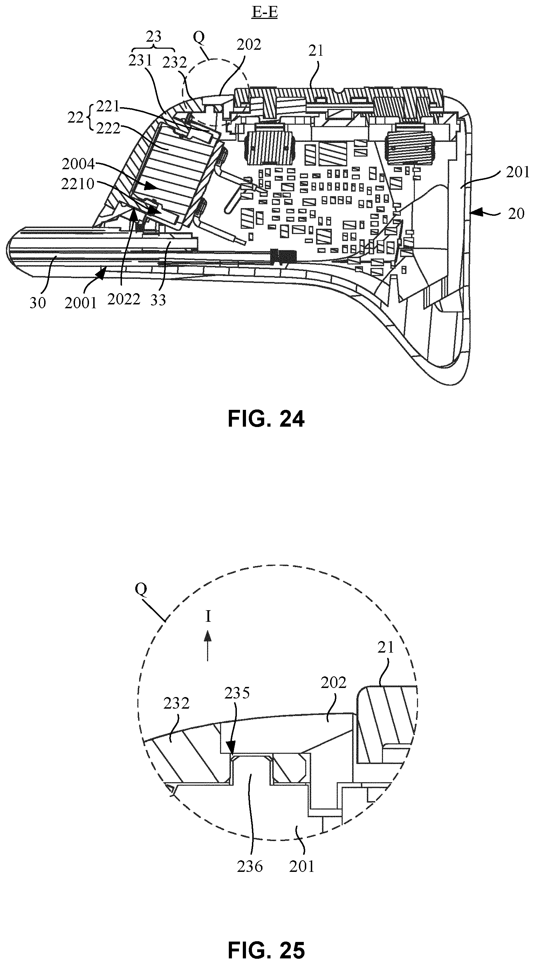

Specifically, as shown in FIG. 23 and FIG. 24, the dust plug 23 may include the plug body 231 and the fixing portion 232, and the fixing portion 232 may be limited to the housing 201 by the housing 202. The plug body 231 is connected to the fixing portion 232 and is configured to selectively shield the interface assembly 22.

The plug body 231 is capable of moving relative to the interface assembly 22 so as to selectively shield or expose the interface assembly 22. The fixing portion 232 connects the plug body 231 to pull the plug body 231, such that the plug body 231 is still connected to the housing assembly 20 through the fixing portion 232 when exposing the interface assembly 22, and thus is less likely to fall off from the headphone 100.

By disposing the dust plug 23 to selectively cover the interface assembly 22, the interface assembly 22 may not be shielded by the dust plug 23 when the interface assembly 22 is not connected to the corresponding plug for use, so as to reduce a situation where impurities, such as dust particles, fall into the interface assembly 22 and block the interface assembly 22 and affect the use of the interface assembly 22. The fixing portion 232 of the dust plug 23 is limited to the housing 201 through the housing 202, and the housing 201 and the housing 202 are configured to fix the dust plug 23 together to make the assembly of the dust plug 23 more stable, or the fixing portion 232 may not be directly fixed on the housing 201, so that no corresponding fixed position is disposed on the shell 201, and the structures of the housing 201 and the housing 202, as well as an assembly manner of the dust plug 23 are simplified.

As shown in FIGs. 23-28, the main body portion 221 may be provided with the first guiding cavity 2210, the wire arrangement portion 222 is disposed in the first guiding cavity 2210, the housing 202 is disposed with the second guiding cavity 2022. The second guiding cavity 2022 is connected to the first guiding cavity 2210, and the plug body 231 is disposed to be able to selectively insert into or remove from the first guiding cavity 2210.

Specifically, the main body portion 221 is configured for plugging an external interface corresponding to the interface assembly 22. The wire arrangement 222 protrudes from the first guiding cavity 2210 and extends into the second guiding cavity 2022. After the external interface is plugged in, the wire arrangement portion 222 is configured to enable the headphone 100 to be electrically connected to the external device through the wire arrangement portion 222. In the above manner, the first guiding cavity 2210 and the second guiding cavity 2022 are made to collectively accommodate the wire arrangement portion 222, which enables the wire arrangement portion 222 to be conveniently plugged.

In some embodiments, the plug body 231 may be inserted into the first guiding cavity 2210 through the second guiding cavity 2022 to shield the interface assembly 22. A shape of the plug body 231 may be adapted to the first guiding cavity 2210 and the wire arrangement portion 222 such that the wire arrangement portion 222 is less likely to obstruct the plug body 231 from being inserted into the first guiding cavity 2210. By disposing the second guiding cavity 2022 to be connected to the first guiding cavity 2210, the interface assembly 22 may not have a complete guiding cavity. On the one hand, is able to the volume of the interface assembly 22 is reduced, and the volume of the entire housing assembly 20 is further reduced.

Through the connection between the second guiding cavity 2022 and the first guiding cavity 2210, the interface assembly 22 may be pressed between the housing 201 and the housing 202, which facilitates the mounting of the interface assembly 22. An inserted portion of the plug body 231 is set to be able to fit into the second guiding cavity 2022 and the first guiding cavity 2210, so that the plug body 231, even after being inserted into the first guiding cavity 2210, is also able to be fixed relative to the interface assembly 22 instead of easily falling off from the first guiding cavity 2210 and the second guiding cavity 2022.

In some embodiments, when inserted into the first guiding cavity 2210, a side of the plug body 231 away from the interface assembly 22 may completely cover the second guiding cavity 2022 to completely shield the interface assembly 22, making it less likely for the impurities such as dust, metal particles, etc. to fall into the interface assembly 22.

In some embodiments, the plug body 231 may be an elastomer made of an elastic material such as the silicone, the rubber, etc., so as to allow the plug body 231 to selectively inserted into or removed out of the first guiding cavity 2210. During the process, the plug body 231 is less prone to damage the Interface assembly 22.

By setting the second guiding cavity 2022 and the first guiding cavity 2210, it is easy for the plug body 231 to be selectively inserted into or removed out of the first guiding cavity 2210 to allow the plug body 231 to selectively shield the interface assembly 22, thereby reducing a situation where the impurities such as the dust, the metal particles, etc. falling into the interface assembly 22.

In some embodiments, as shown in FIG. 23-28, the insert member 33 is inserted within the insert groove 2001, and the fixing portion 232 is located on a side of the interface assembly 22 away from the insert member 33. Specifically, as shown in FIG.24, the fixing portion 232 and the insert member 33 are located on both sides of the interface assembly 22, so that the positions of the dust plug 23 and the insert member 33 do not interact with each other, the space of the headphone 100 is saved, and the space utilization rate of the headphone 100 is improved.

In some embodiments, the fixing portion 232 is disposed between the key assembly 21 and the interface assembly 22 to save a using space of the headphone 100 reduce the volume of the headphone 100, and improve the space utilization of the headphone 100.

In some implementations, as shown in FIGs. 24-29, the housing 202 is connected to the housing 201, and the fixing portion 232 is pressed and limited to the housing 201. Specifically, the housing 202 is capped over the housing 201, and the fixing portion 23 is partially disposed in the housing 201 and is limited to the housing 201 while being pressed by the housing 202. In this way, the assembly of the dust plug 23 is more convenient, and the headphone 100 is easily disassembled and maintained.

In some embodiments, as shown in FIG. 25, a positioning hole 235 may be disposed on the first of the fixing portion 232 and the housing 201, and a positioning post 236 may be disposed on the second of the fixing portion 232 and the housing 201. The positioning post 236 is inserted within the positioning hole 235, and the housing 202 presses and limits the fixed portion 232 on the housing 201 at a periphery of the positioning hole 235.

By disposing the positioning holes 235 and the positioning posts 236, the fixing portion 232 is connected to the housing 201, and then the housing 202 is configured to press and limit the positioning post 236 to the positioning holes 235 at the periphery of the positioning holes 235, then the fixing portion 232 may be fixed on the housing 201. Such setting facilitates the assembly and disassembly of the fixing portion 232, the housing 201, and the housing 202, and at the same time makes the structure of the headphone 100 more compact, and the fixing portion 232 may be more stably limited to the housing 201.

In some embodiments, the fixing portion 232 may be the elastomer, the positioning hole 235 may be disposed on the fixing portion 232, the positioning post 236 may be disposed on the housing 201, and the positioning post 236 may be inserted relative to the positioning hole 235 at a depth smaller than a hole depth of the positioning hole 235. Specifically, positions of the positioning hole 235 on the fixing portion 232 and the positioning post 236 on the housing 201 may correspond to each other, the positioning post 236 is inserted in the positioning hole 235, and an extension direction of the positioning post 236 may be as shown by the I arrow in FIG. 25. The housing 202 may be pressed toward a direction of the positioning post 236 in the extension direction of the positioning post 236, so that the fixing portion 232 is fixed to the housing 201 after the housing 201 is connected and fixed to the housing 202.

The fixing portion 232 may be the elastomer such as the silicone, the rubber, etc. By setting the insertion depth of the positioning holes 235 less than the hole depth of the positioning holes 235, the fixing portion 232 may have a certain compression space in the extension direction of the positioning post 236, and the fixing portion 232 may undergo an elastic deformation when pressed by the housing 202 and the housing 201, and thus is fixed and limited by the housing 201 and the housing 202, so that the fixing portion 232 is more securely limited to the housing 201 and is not prone to loosening, thereby improving a structural tightness and solidity of the headphone 100.

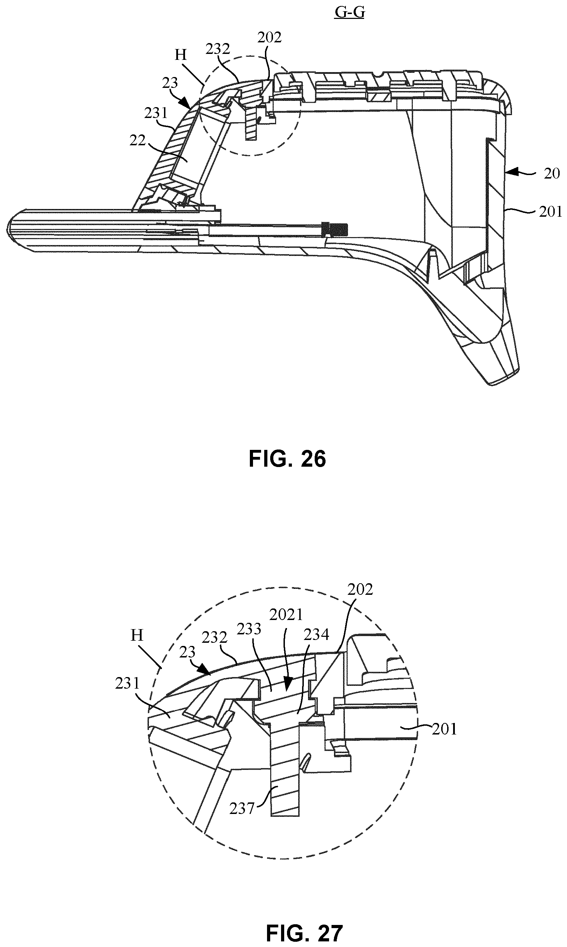

In some other embodiments, the housing 202 is connected to the housing 201, and the fixing portion 232 is connected to the housing 202, as shown in FIGs. 26-27. The housing 202 and the housing 201 are fixedly covered with each other, by connecting the fixing portion 232 to the housing 202, the fixing portion 232 is limited to the housing 201.

In some embodiments, as shown in FIG. 27, a mounting hole 2021 may be disposed in the housing 202, and the dustproof plug 23 may further comprise a connection post 233 connected to the fixing portion 232, and a stopper 234 connected to the connection post 233, the connection post 233 is inserted in the mounting hole 2021, the fixing portion 232 and the stopper 234 are stopped on both sides respectively. The connection post 233 is inserted in the mounting hole 2021, and the fixing portion 232 and the stopper 234 are clamped to the two sides of the housing 202 respectively.

Specifically, one end of the fixing portion 232 is connected to the plug body 231, and one end far from the plug body 231 is connected to the connection post 233. The fixing portion 232 and the stopper 234 are respectively disposed at the two ends of the connection post 233, and the plug body 231 is fixed to the housing 202 through the fixing portion 232 and the stopper 234. The stopper 234 is disposed in a gap between the housing 202 and the housing 201, and is capable of being blocked by the housing 202 and fixed relative to the housing 202 and the housing 201, so that the stopper 234 is less likely to move in the direction of the housing 202 and fall off from the housing 202.

In some embodiments, the stopper 234 is the elastomer and is disposed so as to be able to pass through the mounting hole 2021 under an action of an external traction force. The stopper 234 may be the elastomer such as the silicone, the rubber, etc., which is capable of elastically deforming under the external force and recovering to an original state when the external force is removed.

Based on the foregoing description, the dust plug 23 may further include a traction portion 237. The traction portion 237 is connected to an end of the stopper 234 away from the connection post 233. The traction portion 237 is configured to be pulled to drive the stopper 234 through the mounting hole 2021 under the action of the external traction force, thereby completing the assembly of the fixing portion 232. And, after passing through the mounting hole 2021, the fixing portion 234 may be compressed in the gap between the housing 202 and the housing 201, so that the mounting hole 2021 is fixed relative to the housing 202 and the housing 201, and it is not easy to rotate, loosening, or disengage from the mounting hole 2021 so as to dislodge the dust plug 23. After the stopper 234 passes through the mounting hole 2021 and is fixed, the traction portion 237 may be removed, for example, sheared off, which saves the internal space of the housing 201 and improves the space utilization of the headphone 100.

By setting the stopper 234 as the elastomer, the dust plug 23 is made easy to assemble to simplify an assembling process of the headphone 100, and it further facilitates the disassembly of the dust plug 23 for maintenance, and enables the connection structure of the headphone 100 more tight and stabilized.

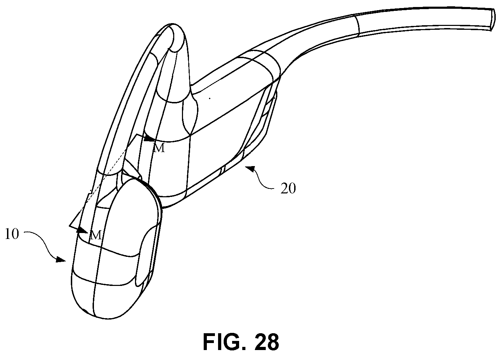

As shown in FIG. 28 to FIG. 31, the housing assembly 10 is provided with an insert groove 1008. The wearing assembly 27 includes a lead assembly 271 and an insert member 272. The insert member 272 includes an insert body 2721 that is insertable within the insert groove 1008. The lead assembly 271 is threaded within the insert body 2721, and has an exposed portion 2711 that is externally exposed from an inner end surface of a side of the insert body 2721 towards the interior of the housing assembly 10. The insert member 272 further includes an annular rib 2722 protruding from the inner end surface, and the annular rib 2722 is disposed around the exposed portion 2711 so that an inner annular surface of the annular rib 2722 forms a first adhesive receiving groove 2723 at a periphery of the exposed portion 2711. The annular rib 2722 and the insert body 2721 may be integrally molded. The annular rib 2722 may also be considered as a portion of the insert body 2721.

A waterproof seal is achieved by filling the first adhesive receiving groove 2723 with adhesive, which in turn seals an assembly gap between the lead assembly 271 and the insert body 2721. Furthermore, as the first adhesive receiving groove 2723 is formed by the inner annular surface of the annular rib 2722 at the periphery of the exposed portion 2711 of the lead assembly 271, the lead assembly 271 and the insert body 2721 are more tightly connected, thereby improving the connection stability between the lead assembly 271 and the insert body 2721.

Referring to FIGs. 28-33, in some embodiments, an outer annular surface of the annular rib 2722 cooperates with the groove wall to form a second adhesive receiving groove 2724. The second adhesive receiving groove 2724 holds the adhesive for the assembly gap between the housing assembly 10 and the insert body 2721 for a corresponding waterproof seal. In some embodiments, by filling the second adhesive receiving groove 2724 with the adhesive, the housing assembly 10 may be connected to the inset body 2721 more tightly, thereby preventing the inset body 2721 from wobbling in the housing assembly 10.

In some embodiments, the second adhesive receiving groove 2724 is disposed in an annular shape around the periphery of the annular rib 2722, allowing the sealant to achieve an annular and more comprehensive sealing around the periphery of the annular rib 2722 to reduce an entry of the water vapor etc., into the housing assembly 10 through the groove gap between the insert body 2721 and the groove wall of the insert groove 1008.

Referring to FIGs. 28-32, in some embodiments, a depth of the first adhesive receiving groove 2723 is greater than a depth of the second adhesive receiving groove 2724 in the insertion direction of the insert member 272 relative to the insert groove 1008, so as to enable the first adhesive receiving groove 2723 to hold more adhesive, which in turn improves a fixing effect and a sealing effect on the lead assembly 271. The shallower second adhesive receiving groove 2724 may enable the insert body 2721 to have more region connecting to the insert groove 1008, which improves an insert fixing effect, and the adhesive within the second adhesive receiving groove 2724 may also provide a good sealing effect.

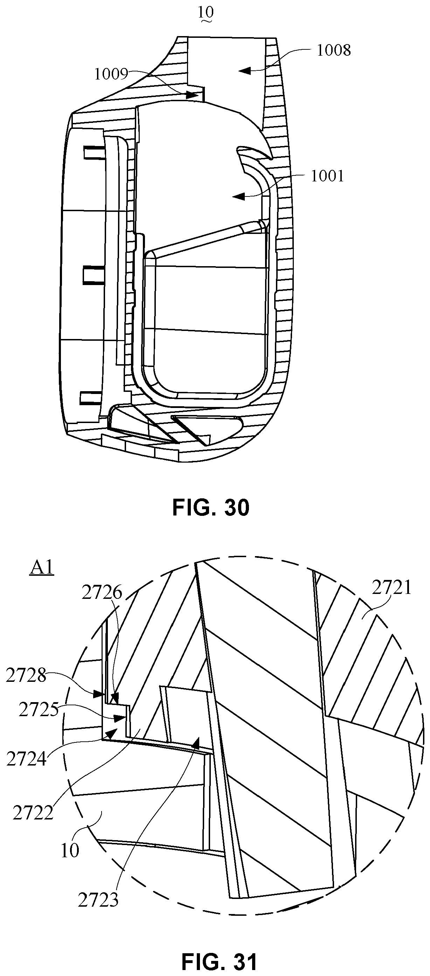

In some embodiments, as shown in FIG. 31, the outer annular surface of the annular rib 2722 includes a first outer annular sub-surface 2725, a connection surface 2726, and a second outer annular sub-surface 2728. The first outer annular sub-surface 2725 is closer to the interior of the housing assembly 10 as compared to the second outer annular sub-surface 2728, a gap between the first outer annular sub-surface 2725 and the groove wall is greater than a gap between the second outer annular sub-surface 2728 and the groove wall. The connection surface 2726 connects the first outer annular sub-surface 2725 and the second outer annular sub-surface 2728, and the first outer annular sub-surface 2725, the connection surface 2726, and the groove wall of the insert groove 1008 fit together to form the second adhesive receiving groove 2724.

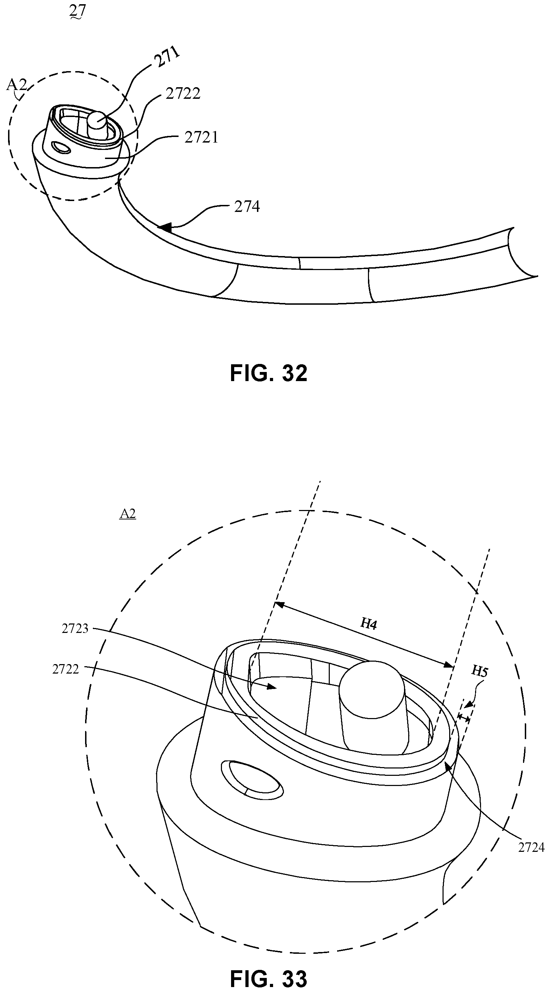

Referring to FIGs. 28-33, in some embodiments, in a direction perpendicular to the insertion direction of the insert member 272 relative to the insert groove 1008, a width H4 of the first adhesive receiving groove 2723 is greater than a width H5 of the second adhesive receiving groove 2724. The width H5 shown in FIG. 33 is labeled on the annular rib 2722 only, but should be understood to be a distance between the first outer annular sub-surface 2725 of the annular rib 2722 and a corresponding groove wall of the insert groove 1008. In this way, on the one hand, the first adhesive receiving groove 2723 may hold more adhesive, which in turn improves the fixing effect and the sealing effect on the lead assembly 271, and on the other hand, the sealing of the second adhesive receiving groove 2724 may be satisfied with less adhesive. Furthermore, as the width H5 of the second adhesive receiving groove 2724 is smaller than the width H4 of the first adhesive receiving groove 2723. A distance between the outer annular surface of the annular rib 2722 and the groove wall is shortened, which improves an adhesive pressure of the second adhesive receiving groove 2724, so that the sealant within the second adhesive receiving groove 2724 further enters the gap between the outer annular surface of the annular rib 2722 and the groove wall.

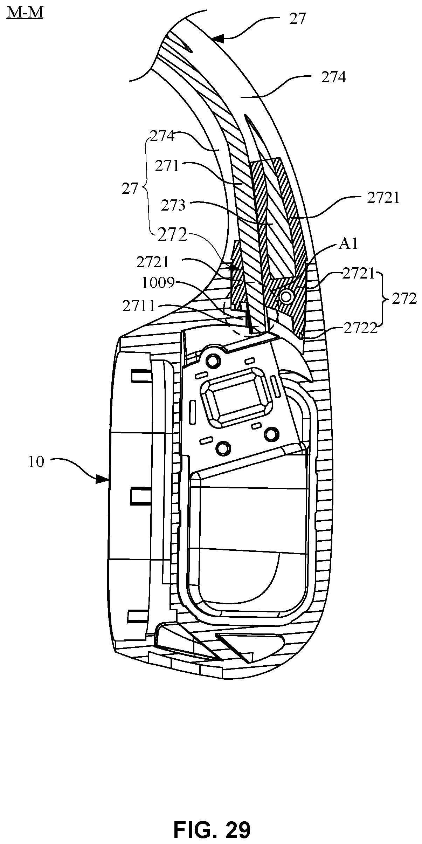

Referring to FIG. 29 and FIG. 30, in some embodiments, the housing assembly 10 is provided with the receiving cavity 1001 connected to the insert groove 1008. The housing assembly 10 includes a limiting member 1009 disposed between the receiving cavity 1001 and the insert groove 1008. The limiting member 1009 is configured to abut against the insert body 2721. Specifically, the limiting member 1009 may abut against the annular rib 2722 to limit an insert depth of the insert body 2721 relative to the insert groove 1008.

Referring to FIG. 30 to FIG. 31, in some embodiments, when viewed from a side of the receiving cavity 1001, at least a portion of the first adhesive receiving groove 2723 and/or the second adhesive receiving groove 2724 is not shielded by the limiting member 1009 to facilitate an application of the sealant into the first adhesive receiving groove 2723 and the second adhesive receiving groove 2724. For example, at least a portion of the first adhesive receiving groove 2723 is not shielded by the limiting member 1009. As another example, at least a portion of the second adhesive receiving groove 2724 is not shielded by the limiting member 1009. For a further example, at least a portion of the first adhesive receiving groove 2723 and a portion of the second adhesive receiving groove 2724 are not shielded by the limiting member 1009. In this way, it is ensured that the adhesive is filled from a side of the first adhesive receiving groove 2723 and/or the second adhesive receiving groove 2724 not shielded by the limiting member 1009.

Referring to FIG. 29 and FIG. 30, in some embodiments, when viewed from the side of the receiving cavity 1001, an area of a region of the first adhesive receiving groove 2723 that is shielded by the limiting member 1009 is less than an area of a region that is not shielded by the limiting member 1009 and/or an area of a region of the second adhesive receiving groove 2724 that is shielded by the limiting member 1009 is less than an area of a region that is not shielded by the limiting member 1009.

As the area of the region shielded by the limiting member 1009 is smaller than the area of the region not blocked by the limiting member 1009, the area of the region available for the application of the adhesive is effectively increased, and the efficiency of the adhesive application is improved.

Referring to FIG. 29 and FIG. 30, in some embodiments, a groove opening position of the region of the first adhesive receiving groove 2723 that is not shielded by the limiting member 1009 is closer to the receiving cavity 1001 compared to a groove opening position of the region of the first adhesive receiving groove 2723 that is shielded by the limiting member 1009, and/or a groove opening position of the region of the second adhesive receiving groove 2724 that is not shielded by the limiting member 1009 is closer to the receiving cavity 1001 compared to a groove opening position of the region of the second adhesive receiving groove 2724 that is shielded by the limiting member 1009. In this way, the adhesive application is further facilitated, and the probability of the adhesive application is increased.

In some embodiments, in a direction from a side that is never shielded by the limiting member 1009 to a side that is shielded by the limiting member 1009, a groove bottom of the first adhesive receiving groove 2723 and/or the second adhesive receiving groove 2724 is tilted in a direction away from the receiving groove 1001, thereby facilitating a flow of adhesive along the bottom of the groove from the side not shielded by the limiting member 1009 to the side shielded by the limiting member 1009, thereby improving the efficiency of the adhesive application.

Referring to FIG. 29, in some embodiments, the wearing assembly 27 further includes an elastic metal wire 273 and a wrapping member 274. The elastic metal wire 273 and the lead assembly 271 are disposed to penetrate from an outer end surface of a side of the insert body 2721 away from the interior of the housing assembly 10 into the insert body 2721. The wrapping member 274 is disposed to wrap the side of the insert body 2721 away from the interior of the housing assembly 10 along a circumference direction of the insert body 2721, and to leave a side of the insert body 2721 toward the interior of the housing assembly 10 exposed.

Referring to FIG. 29 and FIG. 30, the wrapping member 274 circumferentially wraps the insert body 2721 that is not inserted into the insert slot 1008. The wrapping member 274 may be a rubber member or a silicone member, so as to be waterproof to protect the elastic metal wire 273, the lead assembly 271, and the insert body 2721 that are not inserted into the housing assembly 10, which is conducive to improving a cosmetic quality of the headphone 100.

The foregoing describes the movement assembly 1 and the earhook assembly 2, and the following describes a structure of the rear hanging assembly 3 of the headphone 100, etc.

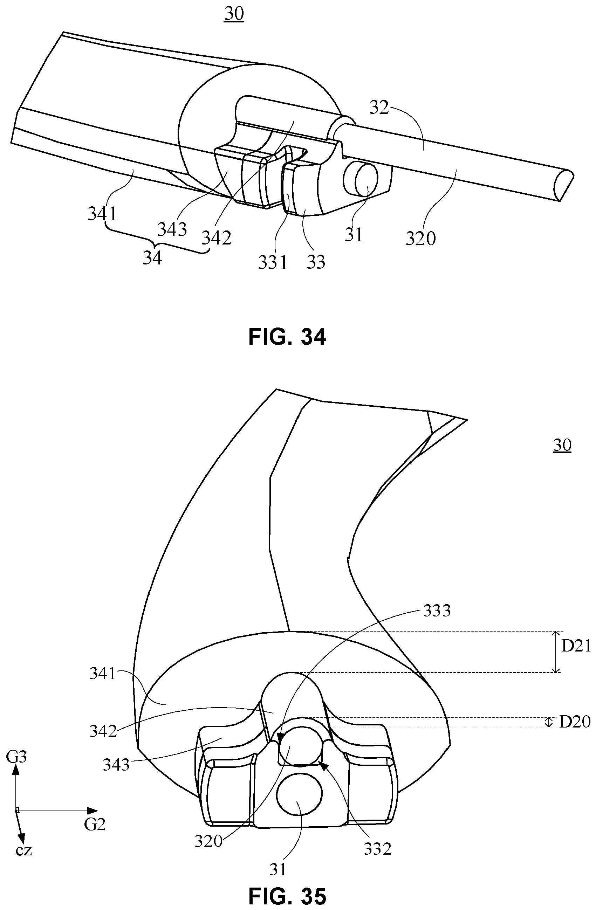

As shown in FIG. 34, the rear hanging assembly 3 includes the wearing assembly 30. The wearing assembly 30 may include an elastic metal wire 31, a lead assembly 32, an insert member 33, and a wrapping assembly 34.

In some embodiments, the elastic metal wire 31 may be made of a titanium alloy, or other metals or alloys that provide an elasticity, which is not limited herein. The insert member 33 is fixed to an end of the elastic metal wire 31.

In some embodiments, the insert member 33 further includes the insert body 331, and the lead assembly 32 has an exposed portion 320 that is exposed from a body wrapping portion 341 and extends to the insert body 331.

In some embodiments, at least one of the insert body 331 and the wrapping assembly 341 is configured to wrap a periphery of the exposed portion 320.

In some embodiments, the wrapping assembly 341 is configured to wrap the periphery of the exposed portion 320. Specifics of the wrapping assembly 341 further wrapping the periphery of the exposed portion 320 are described as follows.

In some embodiments, the wrapping assembly 34 includes the body wrapping portion 341 and an epitaxial wrapping portion 342. The body wrapping portion 341 is configured to wrap the elastic metal wire 31 and a periphery of the lead assembly 32. The epitaxial wrapping portion 342 is configured to wrap the periphery of the exposed portion 320 of the lead assembly 32, while the epitaxial wrapping portion 342 partially wraps the insert body 331 at a circumference of the insert body 331.

The inventor of the present disclosure has found in a long-term study that, after the above-mentioned wearing assembly 30 is connected and mated with the housing assemblies 20, 26, etc., the adhesive may be further applied for fixing, and the adhesive often directly contacts the lead assembly 32, and due to a poor bonding between a plastic material (e.g., Teflon) on an outer surface of the lead assembly 32 and the adhesive, on the one hand, an unstable fixing effect may be caused, and on the other hand, the sealing between a mating structure and the housing assembly 20/26 may also be poor. Due to a softness of the lead assembly 32, a yield of the mating between the wearing assembly 30 and the housing assemblies 20 and 26 is low. Therefore, by adding the epitaxial wrapping portion 342 to protect the exposed portion 320, the adhesive may not directly contact the exposed portion of the lead assembly 32, thereby enhancing the bonding effect of the adhesive by the epitaxial covering portion 342, the fixing effect and the sealing effect may be improved, and a mounting yield of the wearing assembly 30 may also be improved. Furthermore, the epitaxial wrapping portion 342 partially covers the insert body 331 on the circumference of the insert body 331, which allows the insert body 331 to be partially exposed on the circumference to ensure a structural strength of the mating.

In some embodiments, as shown in FIG. 35, a thickness D20 of the epitaxial wrapping portion 342 is less than a thickness D21 of the body wrapping portion 341, and the epitaxial wrapping portion 342 is connected to the body wrapping portion 341 and forms a step structure.

In some embodiments, the epitaxial wrapping portion 342 is integrally molded with the body wrapping portion 341. Specifically, the epitaxial wrapping portion 342 is integrally molded with the body wrapping portion 341 by injection, molding, etc. Of course, the epitaxial wrapping portion 342 may also be disposed separately from the body wrapping portion 341. For example, the epitaxial wrapping portion 342, which is disposed in a tubular shape, is pre-molded, and suited to the periphery of the exposed portion 320.

In some embodiments, a surface of the insert body 331 is disposed with a receiving groove 332. The receiving groove 332 has an opening 333 in a cross section perpendicular to an insertion direction cz of the insert body 331. The exposed portion 320 is disposed in the receiving groove 332. The epitaxial wrapping portion 342 is integrally molded with the body wrapping portion 341. When viewing from an opening direction of the opening 333 of the receiving groove 332, at least a portion of the exposed portion 320 disposed within the receiving groove 332 has an externally visible region. The externally visible region is wrapped by the epitaxial wrapping portion 342. In some embodiments, the length direction of the receiving groove 332 is disposed along the insertion direction cz, and it is understood that the length direction of the receiving groove 332 is the same as the insertion direction cz.

In some embodiments, the epitaxial wrapping portion 342 fills a gap between the exposed portion 320 and the groove wall of the receiving groove 332.

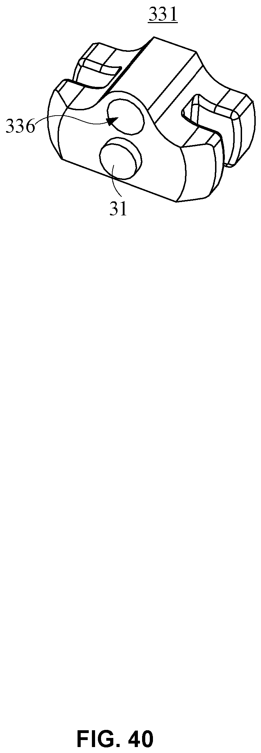

In some embodiments, as shown in FIG. 35 and FIG. 40, the wrapping assembly 34 further includes an epitaxial insert portion 343 integrally molded with the body wrapping portion 341. The epitaxial insert portion 343 contacts an end surface of a side of the insert body 331 toward the body wrapping portion 341 toward an end surface of the side of the body wrapping portion 341. The epitaxial insert portion 343 may be inserted into the insert groove 2001 of the housing assembly 20 with the insert body 331. By disposing the epitaxial insert portion 343, an insert depth of the insert body 331 may be increased, which in turn improves a structure stability.

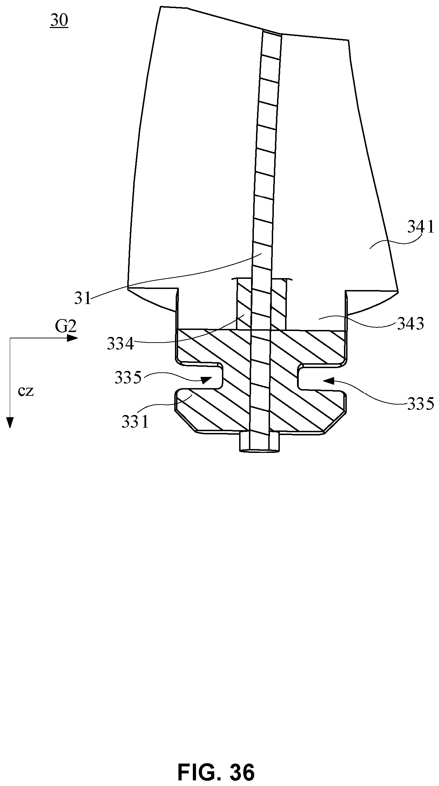

As shown in FIG. 36, in some embodiments, the insert member 33 further includes an epitaxial positioning portion 334 protruding at an end surface of the insert body 331, and the epitaxial positioning portion 334 is embedded within the epitaxial insert portion 343. By disposing the epitaxial positioning portion 334 embedded within the epitaxial insert portion 343, an area of a contact interface between the insert body 331 and the wrapping assembly 34 is increased, thereby enhancing the stability between the insert body 331 and the wrapping assembly 34.

In some other embodiments, when there is no epitaxial insert portion 343, the epitaxial positioning portion 334 protrudes from the end surface of the insert body 331 toward the side of the body wrapping portion 341, and the epitaxial positioning portion 334 is embedded in the body wrapping portion 341, and the area of the contact interface between the inserted body 331 and the wrapping assembly 34 is likewise increased.

In some embodiments, the elastic metal wire 31 is threaded through the epitaxial positioning portion 334 to improve a fixing effect of the elastic metal wire 31 and the insert member 33.

In some embodiments, as shown in FIG. 35, in the cross section perpendicular to the insertion direction cz of the insert body 331, the insert body 331 has a length direction G2 and a width direction G3. The exposed portion 320 and the elastic metal wire 31 are spaced apart along the width direction G3. A machinability of the insert member 33 is increased by setting the exposed portion 320 and the elastic metal wire 31 spaced apart along the width direction G3 of the insert body 331.

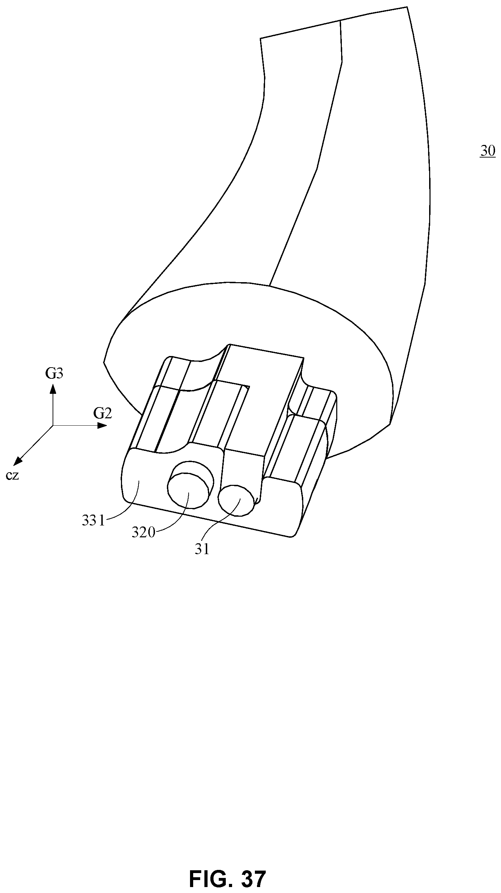

As shown in FIG. 37, in some other embodiments, the exposed portion 320 is spaced apart from the elastic metal wire 31 along the length direction G2. As the insert body 331 is relatively limited in size in the width direction G3, and by setting the exposed portion 320 spaced apart from the elastic metal wire 31 along the length direction G2 in the insert body 331, the space utilization of the insert member 33 is improved.

As shown in FIG. 36, the insert body 331 is disposed with two slots 335 spaced apart along the length direction G2, and the exposed portion 320 and the elastic metal wire 31 are disposed between the two slots 335 in the length direction G2.

In some embodiments, a covering width of the epitaxial wrapping portion 342 over the insert body 331 along a circumferential direction of the insert body 331 is less than or equal to one-fourth of a maximum circumferential length of the insert body 331. The maximum circumferential length refers to a maximum circumference of the insert body 331 in a reference plane perpendicular to the insertion direction cz when the exposed portion 320 and the epitaxial wrapping portion are not covered.

The sealant is configured to seal a gap from at least one of the insert body 331 and the exposed portion 320 of the wrapping assembly 34 to a groove wall of the insert slot 2001. Surface wettability of the sealant on a surface of the at least one of the insert body 331 and the exposed portion 320 of the wrapping assembly 34 is greater than surface wettability of the sealant on a surface of the lead assembly 32.

The housing assembly 20 of the earhook assembly 2 is disposed with the insert groove 2001, and the epitaxial wrapping portion 342 and the epitaxial insert portion 343 as described above are inserted into the insert groove 2001 with the insert body 331. In some embodiments, the headphone 100 also includes the sealant (not shown) configured to seal the gap between the insert body 331 and the slot wall of the insert slot 2001 and the gap between the slot wall of the insert slot 2001 and the epitaxial wrapping portion 342. The surface wettability of the sealant on the surface of the epitaxial wrapping portion 342 is greater than the surface wettability of the sealant on the surface of the lead assembly 32.

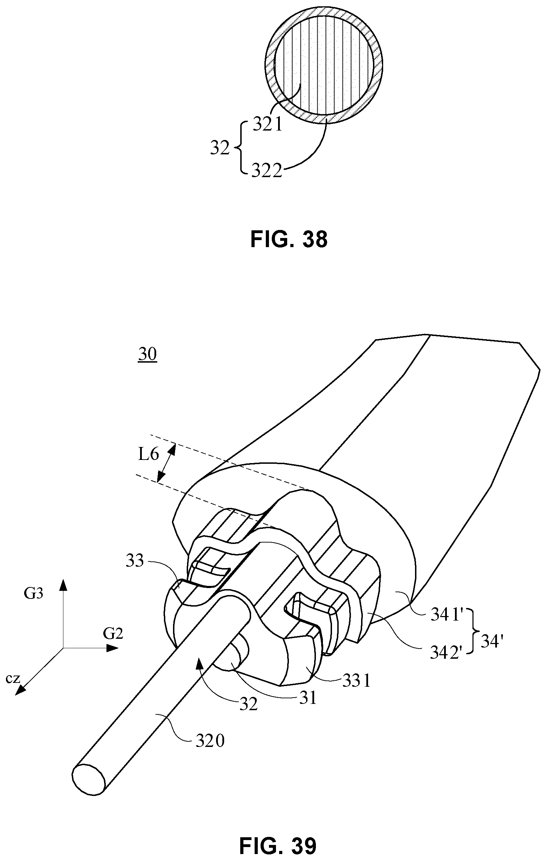

As shown in FIG. 38, the lead assembly 32 includes a lead body 321 and an insulating layer 322 wrapped in a periphery of the lead body 321. In some embodiments, a material of the insulating layer 322 is polytetrafluoroethylene, and a material of the epitaxial wrapping portion 342 is silicone. The surface wettability of the sealant on the surface of the epitaxial cladding portion 342 is greater than the surface wettability of the sealant 2002 on a surface of the insulating layer 322. In this way, a better bonding effect between the sealant and the epitaxial wrapping portion 342 is achieved, and the sealing effect and the fixing effect may be effectively improved, which in turn enables the headphone 100 to have a good waterproof effect.

One exemplary structure of the wearing assembly 30 described above mentions that the wrapping assembly 34 further wraps the exposed portion 320. Another exemplary structure of the wearing assembly 30 where the insert body 331 further wraps the exposed portion 320 is described below.

As shown in FIG. 39, the wearing assembly 30 may specifically include the elastic metal wire 31, the lead assembly 32, the insert member 33, and a wrapping assembly 34'. The insert member 33 is fixed to an end portion of the elastic metal wire 31. The insert member 33 further includes the insert body 331. The wrapping assembly 34' includes a body wrapping portion 341'. The body wrapping portion 341' is configured to wrap the periphery of the elastic metal wire 31 and the lead assembly 32. The lead assembly 32 has the exposed portion 320 that is exposed from the body wrapping portion 341' and extends to the insert body 331.

In some embodiments, the inset body 331 may be configured to wrap around the periphery of the exposed portion 320. As shown in FIG. 40, the insert body 331 is disposed with a hole path 336. The exposed portion 320 of the lead assembly 32 penetrates the hole path 336. For example, the hole path 336 on the insert body 331 is preformed, with the exposed portion 320 subsequently inserted into and through the hole path 336.

By adding the hole path 336 on the insert body 331 to protect the exposed portion 320, the adhesive may not directly contact the exposed portion of the lead assembly 32, and the insert body 331 may contact the adhesive to enhance the bonding effect, thereby improving the fixing effect and the sealing effect, and improving the mounting yield of the wearing assembly 30. Furthermore, the insert body 331 may provide a better protection for the lead assembly 32 through the exposed portion 320 surrounding the hole path 336.

In some embodiments, a hole wall of the hole path 336 closely surrounds the periphery of the exposed portion 320 along a circumferential direction of the exposed portion 320.

In some embodiments, as shown in FIG. 39, the wrapping assembly 34' further includes an epitaxial wrapping portion 342' integrally molded with the body wrapping portion 341'. The epitaxial wrapping portion 342' wraps an end of the insert body 331 towards the body wrapping portion 341' along the circumferential direction of the insert body 331. An end of the insert body 331 away from the body wrapping portion 341' is exposed, thereby improving the waterproofing effect of an end surface of the insert body 331 toward the side of the body wrapping portion 341'.

In the insert direction cz of the insert body 331, a wrapping length L6 of the epitaxial wrapping portion 342' on the insert body 331 is in a range of 0.2 mm-2.0 mm.

Referring to the above embodiment, In some embodiments, the insert member 33 further includes the epitaxial positioning portion 334 (the epitaxial positioning portion 334 may refer to the epitaxial positioning portion illustrated in FIG. 36). The epitaxial positioning portion 334 protrudes from an end surface of a side of the insert body 331 toward the body wrapping portion 341', and the epitaxial positioning portion 334 is embedded within the body wrapping portion 341'. Similarly, the elastic metal wire 31 is threaded within the epitaxial positioning portion 334.

Referring to the above embodiment, in the cross section perpendicular to the insertion direction cz of the insert body 331 relative to the insert groove 2001, the insert body 331 has a length direction G2 and a width direction G3, and in some embodiments, the exposed portion 320 and the elastic metal wire 31 may be spaced apart along the length direction G2, and the exposed portion 320 and the elastic metal wire 31 may also be spaced apart along the width direction G3. The machinability of the insert member 33 is increased by making the exposed portion 320 spaced apart from the elastic metal wire 31 along the width direction G3 of the insert body 331. Of course, an arrangement manner of the exposed portion 320 and the elastic metal wire 31 as well as a manner of disposing the slot may refer to the above embodiments. The housing assembly 20 of the earhook assembly 2 is disposed with the insert groove 2001, and the epitaxial wrapping portion 342' and the hole path 336 described above are inserted into the insert groove 2001 along with the insert body 331.

In some embodiments, the headphone 100 further includes the sealant (not shown). The sealant is configured to seal a gap between at least one of the insert body 331 and the wrapping assembly 34 which wraps the exposed portion 320 and a groove wall of the insert groove 2001. The surface wettability of the sealant on the surface of the at least one of the insert body 331 and the wrapping assembly 34 which wraps the exposed portion 320 is greater than the surface wettability of the sealant on the surface of the lead assembly 32.

In some embodiments, the sealant is configured to seal the gap between the slot body 331 and the slot wall of the insert groove 2001. The surface wettability of the sealant on the surface of the slot body 331 is greater than the surface wettability of the sealant on the surface of the lead assembly 32.

As shown in FIG. 38, the lead assembly 32 includes the lead body 321 and the insulating layer 322 wrapped around the periphery of the lead body 321, and the surface wettability of the sealant on the surface of the epitaxial wrapping portion 342 is greater than the surface wettability of the sealant on the surface of the insulating layer 322.

In some embodiments, the material of the insulating layer 322 may be PTFE and the material of the insert body 331 may be metal. The material of the epitaxial wrapping portion 342 may be silicone. In some embodiments, the material of the insert body 331 may be any one or a combination of one or more metals or alloys, which is not limited herein. By setting the insulating layer to be a high-temperature-resistant and insulating polytetrafluoroethylene material, the wire body is prevented from melting the insulating layer when too much heat is generated.

The foregoing is only a portion of the embodiments of the present disclosure, which is not intended to limit the scope of protection of the present disclosure, and any equivalent device or equivalent process transformations utilizing the contents of the specification of the present disclosure and the accompanying drawings or directly or indirectly applying them in other related fields of technology are similarly included in the scope of patent protection of the present disclosure.

## Claims

1. A wearing assembly comprising an elastic metal wire, a lead assembly, an insert member, and a wrapping assembly, wherein the insert member is fixed to an end of the elastic metal wire and includes an insert body, the wrapping assembly includes a body wrapping portion wrapping a periphery of the elastic metal wire and the lead assembly, the lead assembly has an exposed portion that is exposed from the body wrapping portion and extends to the insert body; at least one of the insert body or the wrapping assembly further wraps a periphery of the exposed portion.

2. The wearing assembly of claim 1, wherein
the insert body is provided with a hole path, and the exposed portion penetrates the hole path.

3. The wearing assembly of claim 2, wherein a hole wall of the hole path surrounds a periphery of the exposed portion along a circumferential direction of the exposed portion in a closed manner.

4. The wearing assembly of claim 2, comprising an epitaxial wrapping portion integrally molded with the body wrapping portion, wherein the epitaxial wrapping portion wraps on an end of the insert body facing the body wrapping portion along a circumferential direction of the insert body, and the other end of the insert body away from the body wrapping portion is exposed.

5. The wearable assembly of claim 4, wherein a wrapping length of the epitaxial wrapping portion over the insert body in an insertion direction relative to the insert body is in a range of 0.2 mm-2.0 mm.

6. The wearing assembly of claim 2, wherein the insert member further includes an epitaxial positioning portion protruding from an end surface of the insert body towards the body wrapping portion, and the epitaxial positioning portion is embedded within the body wrapping portion.

7. The wearing assembly of claim 6, wherein the elastic metal wire is threaded within the epitaxial positioning portion.

8. The wearing assembly of claim 1, wherein in a cross section perpendicular to an insertion direction of the insert body relative to a first insert groove, the insert body has a lengthwise direction and a widthwise direction, and the exposed portion is spaced apart from the elastic metal wire along the lengthwise direction or the widthwise direction.

9. The wearing assembly of claim 8, wherein the insert body is provided with two slots spaced apart along the lengthwise direction, and the exposed portion and the elastic metal wire are disposed between the two slots in the lengthwise direction.

10. The wearing assembly of claim 1, wherein the wrapping assembly further includes an epitaxial wrapping portion wrapping the periphery of the exposed portion of the lead assembly and partially covering the insert body in a circumferential direction of the insert body.

11. The wearing assembly of claim 10, wherein a thickness of the epitaxial wrapping portion is less than a thickness of the body wrapping portion, and the epitaxial wrapping portion is connected to the body wrapping portion to form a step structure.

12. The wearing assembly of claim 10, wherein the epitaxial wrapping portion is integrally molded with the body wrapping portion.

13. The wearing assembly of claim 10, wherein a receiving groove is disposed on a surface of the insert body, and in a cross section perpendicular to an insertion direction of the insert body relative to a first insert groove, the receiving groove has an opening, the exposed portion is disposed within the receiving groove, the epitaxial wrapping portion is integrally molded with the body wrapping portion, and at least a part of the exposed portion disposed within the receiving groove has an externally visible region when viewed from the opening of the receiving groove, and the externally visible region is wrapped by the epitaxial wrapping portion.

14. The wearing assembly of claim 10, wherein a lengthwise direction of the receiving groove is disposed along the insertion direction.

15. The wearing assembly of claim 13, wherein the epitaxial wrapping portion further fills in a gap between the exposed portion and a groove wall of the receiving groove.

16. The wearing assembly of claim 10, wherein the wrapping assembly further includes an epitaxial insert portion integrally molded with the body wrapping portion, and the epitaxial insert portion contacts an end surface of the insert body towards the body wrapping portion.

17. The wearing assembly of claim 16, wherein the insert member further includes an epitaxial positioning portion protruding from the end surface of the insert body, and the epitaxial positioning portion is embedded within the epitaxial insert portion.

18. The wearing assembly of claim 10, wherein the insert member further includes an epitaxial positioning portion protruding from an end surface of the insert body towards the body wrapping portion, and the epitaxial positioning portion is embedded within the body wrapping portion.

19. The wearing assembly of claim 17 or 18, wherein the elastic metal wire is threaded within the epitaxial positioning portion.

20. The wearing assembly of claim 10, wherein in a cross section perpendicular to an insertion direction of the insert body relative to a first insert groove, the insert body has a lengthwise direction and a widthwise direction, and the exposed portion is spaced apart from the elastic metal wire along the lengthwise direction or the widthwise direction.

21. The wearing assembly of claim 20, wherein the insert body is disposed with two slots spaced apart in the lengthwise direction, and the exposed portion and the elastic metal wire are disposed between the two slots in the lengthwise direction.

22. The wearing assembly of claim 10, wherein a covering width of the epitaxial wrapping portion over the insert body in the circumferential direction of the insert body is less than or equal to one-fourth of a maximum circumferential length of the insert body.

23. A headphone comprising the wearing assembly of any one of claims 1-22 and a housing assembly, wherein a housing assembly is disposed with a first insert groove, and the insert body is inserted in the first insert groove.

24. The headphone of claim 23, further comprising a sealant configured to seal a gap between at least one of the insert body or the wrapping assembly which wraps the exposed portion and a groove wall of the first insert groove, wherein surface wettability of the sealant on a surface of the at least one of the insert body or the wrapping assembly which wraps the exposed portion is greater than surface wettability of the sealant on a surface of the lead assembly.

25. The headphone of claim 24, further comprising an epitaxial wrapping portion, wherein the epitaxial wrapping portion wraps the periphery of the exposed portion of the lead assembly and partially covers the insert body in a circumferential direction of the insert body, the epitaxial wrapping portion is inserted into the first insert groove with the insert body; the sealant is configured to seal gaps between the insert body as well as the epitaxial wrapping portion and the groove wall of the first insert groove, wherein the surface wettability of the sealant on a surface of the epitaxial wrapping portion is greater than surface wettability of the sealant on the surface of the lead assembly.

26. The headphone of claim 24, wherein the insert body is disposed with a hole path, the exposed portion penetrates the hole path, and the sealant is configured to seal a gap between the insert body and the groove wall of the first insert groove, wherein the surface wettability of the sealant on a surface of the insert body is greater than the surface wettability of the sealant on the surface of the lead assembly.

27. The headphone of claim 25 or 26, wherein the lead assembly includes a lead body and an insulating coating wrapping a periphery of the lead body, and the surface wettability of the sealant on the surface of the epitaxial wrapping portion is greater than surface wettability of the sealant on a surface of the insulating coating.

28. The headphone of claim 24, wherein a material of the insulating coating is polytetrafluoroethylene (PTFE), and a material of the insert body is metal.
